(19) Europäisches Patentamt
European Patent Office
Office européen des brevets

(11) EP 4 628 535 A1

(12) EUROPEAN PATENT APPLICATION
published in accordance with Art. 153(4) EPC

(43) Date of publication:
**08.10.2025 Bulletin 2025/41**

(21) Application number: **23897439.8**

(22) Date of filing: **10.11.2023**

(51) International Patent Classification (IPC):
***C08L 33/08*** (2006.01) ***B29C 59/02*** (2006.01)
***H01L 21/027*** (2006.01)

(52) Cooperative Patent Classification (CPC):
**B29C 59/02; C08L 33/08; H01L 21/027**

(86) International application number:
**PCT/JP2023/040496**

(87) International publication number:
**WO 2024/116787 (06.06.2024 Gazette 2024/23)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **29.11.2022 JP 2022190577**
**26.09.2023 JP 2023163584**

(71) Applicant: **CANON KABUSHIKI KAISHA**
**Tokyo 146-8501 (JP)**

(72) Inventors:
- **SHIRONO, Jumpei**
**Tokyo 146-8501 (JP)**
- **ITO, Toshiki**
**Tokyo 146-8501 (JP)**
- **MASHIDA, Ayano**
**Tokyo 146-8501 (JP)**
- **OOTSUKA, Masanobu**
**Tokyo 146-8501 (JP)**

(74) Representative: **TBK**
**Bavariaring 4-6**
**80336 München (DE)**

# (54) CURABLE COMPOSITION, FILM FORMING METHOD, AND ARTICLE MANUFACTURING METHOD

(57) In a curable composition containing at least a polymerizable compound (a), a photopolymerization initiator (b), and a solvent (d), a viscosity of the curable composition at 23°C is not less than 1.3 mPa·s and not more than 60 mPa·s, a content of the solvent (d) with respect to the whole curable composition is larger than 5 vol% and not more than 95 vol%, a boiling point of the solvent (d) is less than 250°C, and letting $\gamma 1$ (mN/m) be a surface tension of the curable composition at 23°C in a state in which the solvent (d) is removed, and y2 (mN/m) be a surface tension of the solvent (d) at 23°C, $\gamma 1$ is larger than y2.

FIG. 1

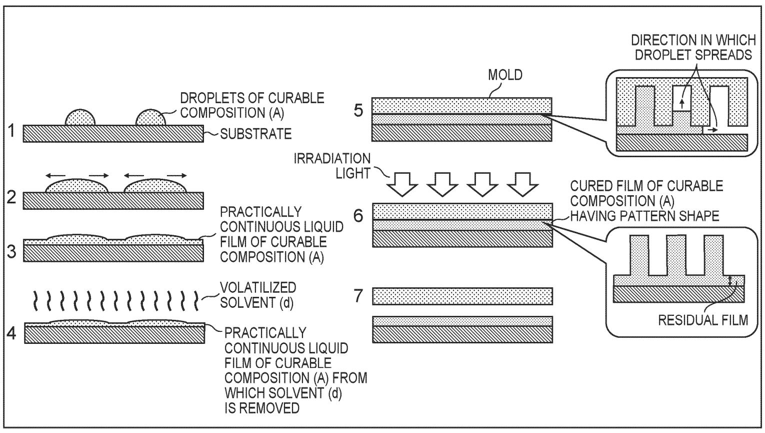


EP 4 628 535 A1

## Description

TECHNICAL FIELD

The present invention relates to a curable composition, a film forming method, and an article manufacturing method.

BACKGROUND ART

For semiconductor devices and MEMS, requirements of miniaturization are increasing, and as a micropatterning technique, an imprint technique (optical imprint technique) has received a great deal of attention as a microfabrication technique. In the imprint technique, a curable composition is cured in a state in which a mold with a fine concave-convex pattern formed on the surface is in contact with the curable composition supplied (applied) onto a substrate. Thus, the pattern of the mold is transferred to the cured film of the curable composition, thereby forming the pattern on the substrate. According to the imprint technique, it is possible to form, on a substrate, a fine pattern (structure) on a several nanometer order (see PTL 1).

As an example of a pattern forming method using the imprint technique, the Jet and Flash Imprint Lithography (JFIL) technique will be described. First, a curable composition in liquid form is discretely dropped (arranged) in a pattern formation region on a substrate. The droplets of the curable composition arranged in the pattern formation region spread on the substrate. This phenomenon is called pre-spreading. Next, a mold is brought into contact with (pressed against) the curable composition on the substrate. Thus, the droplets of the curable composition spread to the whole region of the gap between the substrate and the mold by a capillary phenomenon. This phenomenon is called spreading. Also, by the capillary phenomenon, the curable composition fills concave portions that form the pattern of the mold. This phenomenon is called filling. Note that the time until spreading and filling are completed is called a filling time. If the filling of the curable composition is completed, the curable composition is irradiated with light to cure the curable composition. Then, the mold is released from the cured curable composition on the substrate. By executing these steps, the pattern of the mold is transferred to the curable composition on the substrate, and the pattern of the curable composition is formed. Here, the pattern of the curable composition formed on the substrate can include a residual film. The residual film is a cured film remaining between the substrate and a concave portion of the cured film of the curable composition (a convex portion of the mold pattern).

A photolithography step of fabricating a semiconductor device requires planarization of a substrate. For example, in an extreme ultraviolet exposure technique (EUV) as a photolithography technique attracting attention in recent years, the depth of focus at which a projected image is formed decreases as miniaturization advances, so the unevenness on the surface of a substrate to which a curable composition is supplied must be decreased to a few tens of nm or less. Flatness equivalent to that of EUV is required in an imprint technique as well, in order to improve the filling properties of a curable composition and the line width accuracy (see NPL 1). As a planarization technique, there is known a technique of obtaining a flat surface by discretely dropping, on an uneven substrate, droplets of a curable composition in an amount corresponding to the unevenness, and curing the curable composition in a state in which a mold having a flat surface is in contact with the curable composition (see PTLs 2 and 3).

In the pattern forming method or planarization technique based on the above-described JFIL, since the mold is brought into contact in a state in which the droplets dropped onto the substrate are not in contact with each other, bubbles are inevitably entrapped between the mold, the substrate, and the curable composition. Hence, a long time is needed until the bubbles are diffused to the mold or the substrate and disappear, and this is one of the factors that lower productivity (throughput). To improve the throughput of JFIL, there is known a technique of bonding the droplets of the curable composition to each other before the mold is brought into contact, as shown in PTL 4.

CITATION LIST

PATENT LITERATURE

PTL 1: Japanese Patent No. 6,584,578
PTL 2: Japanese Patent Laid-Open No. 2019-140394
PTL 3: US-2020-0286740
PTL 4: Japanese Patent Laid-Open No. 2010-530641
PTL 5: Japanese Patent Laid-Open No. 2022-99271

NON PATENT LITERATURE

NPL 1: Proc. SPIE 11324-11 (2020)
NPL 2: J. Electrochem. Soc., 130, p. 143 (1983)

SUMMARY OF INVENTION

TECHNICAL PROBLEM

In the JFIL technique described in PTL 4, however, since the curable composition contains a solvent, it is necessary to perform a step of volatilizing the solvent before the mold comes into contact and waiting until the droplets bond to each other. There is a problem that productivity lowers due to the waiting step.

The present invention has been made in consideration of the problem of the conventional technique, and has as its object to provide a novel technique concerning a curable composition.

SOLUTION TO PROBLEM

In order to achieve the above-described object, according to one aspect of the present invention, there is provided a curable composition containing at least a polymerizable compound (a), a photopolymerization initiator (b), and a solvent (d), characterized in that a viscosity of the curable composition at 23°C is not less than 1.3 mPa·s and not more than 60 mPa·s, the content of the solvent (d) with respect to the whole curable composition is larger than 5 vol% and not more than 95 vol%, a boiling point of the solvent (d) is less than 250°C, and letting $\gamma1$ (mN/m) be a surface tension of the curable composition at 23°C in a state in which the solvent (d) is removed, and y2 (mN/m) be a surface tension of the solvent (d) at 23°C, $\gamma1$ is larger than y2.

ADVANTAGEOUS EFFECTS OF INVENTION

According to the present invention, it is possible to provide, for example, a novel technique concerning a curable composition.

Other features and advantages of the present invention will be apparent from the following description taken in conjunction with the accompanying drawings. Note that the same reference numerals denote the same or like components throughout the accompanying drawings.

BRIEF DESCRIPTION OF DRAWINGS

The accompanying drawings, which are incorporated in and constitute a part of the specification, illustrate embodiments of the invention and, together with the description, serve to explain principles of the invention.

Fig. 1 is a view for explaining a pattern forming method (film forming method) according to an embodiment;
Fig. 2 is a view for explaining the behavior of a droplet after dropping;
Fig. 3 is a view for explaining the shape of a droplet in a case where the flow of the droplet is induced by the Marangoni effect;
Fig. 4 is a view for explaining the flow behavior of droplets of a curable composition during a waiting step;
Fig. 5 is a view showing comparison between a contact step in the conventional technique and a contact step according to an embodiment;
Fig. 6 is a view showing a time-rate change of a droplet radius;
Fig. 7 is a view showing the dependence of the maximum radius of droplets on $\Delta\gamma$; and
Fig. 8 is a view showing the dependence of the volatilization time of droplets on $\Delta\gamma$.

DESCRIPTION OF EMBODIMENTS

Hereinafter, embodiments will be described in detail with reference to the attached drawings. Note, the following embodiments are not intended to limit the scope of the claimed invention. Multiple features are described in the embodiments, but limitation is not made to an invention that requires all such features, and multiple such features may be combined as appropriate. Furthermore, in the attached drawings, the same reference numerals are given to the same or similar configurations, and redundant description thereof is omitted.

When providing a novel technique concerning a curable composition, the present inventors found a curable composition in which the droplets of the curable composition discretely dropped (arranged) on a substrate quickly bond to each other, and a solvent contained in the curable composition quickly volatilizes, and a process condition therefor.

[Curable Composition]

A curable composition (A) according to an embodiment of the present invention can be a curable composition for inkjet. The curable composition (A) according to the embodiment is a composition containing at least a component (a) as a polymerizable compound, a component (b) as a photopolymerization initiator, and a component (d) as a solvent.
**In** this specification, a cured film means a film cured by polymerizing the curable composition on a substrate. Note that the shape of the cured film is not particularly limited, so the film can have a pattern shape on the surface.

<Component (a): Polymerizable Compound>

The component (a) is a polymerizable compound. In this specification, the polymerizable compound is a compound that reacts with a polymerization factor (for example, a radical) generated from a polymerization initiator (the component (b)), and forms a film made of a polymer compound by a chain reaction (polymerization reaction).
An example of the polymerizable compound as described above is a radical polymerizable compound. The polymerizable compound as the component (a) can be formed by only one type of polymerizable compound, and can also be formed by a plurality of types (one or more types) of polymerizable compounds.
Examples of the radical polymerizable compound are a (meth)acrylic compound, a styrene-based compound, a vinyl-based compound, an allylic compound, a fumaric compound, and a maleic compound.
The (meth)acrylic compound is a compound having one or more acryloyl groups or methacryloyl groups. Examples of a monofunctional (meth)acrylic compound having one acryloyl group or methacryloyl group are as follows, but the compound is not limited to these examples.
Phenoxyethyl (meth)acrylate, phenoxy-2-methylethyl (meth)acrylate, phenoxyethoxyethyl (meth)acrylate, 3-phenoxy-2-hydroxypropyl (meth)acrylate, 2-phenylphenoxyethyl (meth)acrylate, 4-phenylphenoxyethyl (meth)acrylate, 3-(2-phenylphenyl)-2-hydroxypropyl (meth)acrylate, (meth)acrylate of EO-modified p-cumylphenol, 2-bromophenoxyethyl (meth)acrylate, 2,4-dibromophenoxyethyl (meth)acrylate, 2,4,6-tribromophenoxyethyl (meth)acrylate, EO-modified phenoxy (meth)acrylate, PO-modified phenoxy (meth)acrylate, polyoxyethylenenonylphenylether (meth)acrylate, isobornyl (meth)acrylate, **1-**adamantyl (meth)acrylate, 2-methyl-2-adamantyl (meth)acrylate, 2-ethyl-2-adamantyl (meth) acrylate, bornyl (meth)acrylate, tricyclodecanyl (meth)acrylate, dicyclopentanyl (meth)acrylate, dicyclopentenyl (meth) acrylate, cyclohexyl (meth)acrylate, 4-butylcyclohexyl( meth)acrylate, acryloylmorpholine, 2-hydroxyethyl (meth)acrylate, 2-hydroxypropyl (meth)acrylate, 2-hydroxybutyl (meth)acrylate, methyl (meth)acrylate, ethyl (meth)acrylate, propyl (meth)acrylate, isopropyl (meth)acrylate, butyl (meth)acrylate, amyl (meth)acrylate, isobutyl (meth)acrylate, t-butyl (meth)acrylate, pentyl (meth)acrylate, isoamyl (meth)acrylate, hexyl (meth)acrylate, heptyl (meth)acrylate, octyl (meth)acrylate, isooctyl (meth)acrylate, 2-ethylhexyl (meth)acrylate, nonyl (meth)acrylate, decyl (meth)acrylate, isodecyl (meth)acrylate, undecyl (meth)acrylate, dodecyl (meth)acrylate, lauryl (meth)acrylate, stearyl (meth)acrylate, isostearyl (meth)acrylate, benzyl (meth)acrylate, tetrahydrofurfuryl (meth)acrylate, butoxyethyl (meth)acrylate, ethoxydiethyleneglycol (meth)acrylate, polyethyleneglycol mono(meth)acrylate, polypropyleneglycol mono(meth)acrylate, methoxyethyleneglycol (meth)acrylate, ethoxyethyl (meth)acrylate, methoxypolyethyleneglycol (meth)acrylate, methoxypolypropyleneglycol (meth)acrylate, diacetone (meth)acrylamide, isobutoxymethyl (meth)acrylamide, N,N-dimethyl (meth)acrylamide, t-octyl (meth)acrylamide, dimethylaminoethyl (meth)acrylate, diethylaminoethyl (meth)acrylate, 7-amino-3,7-dimethyloctyl (meth)acrylate, N,N-diethyl (meth)acrylamide, N,N-dimethylaminopropyl (meth)acrylamide, 1- or 2-naphthyl (meth)acrylate, 1- or 2-naphthylmethyl (meth)acrylate, 3- or 4-phenoxybenzyl (meth)acrylate, cyanobenzyl (meth) acrylate, and naphthalene methyl (meth)acrylate
Examples of commercially available products of the above-described monofunctional (meth)acrylic compounds are as follows, but the products are not limited to these examples.
ARONIX® M101, M102, M110, M111, M113, M117, M5700, TO-1317, M120, M150, and M156 (manufactured by TOAGOSEI); MEDOL10, MIBDOL10, CHDOL10, MMDOL30, MEDOL30, MIBDOL30, CHDOL30, LA, IBXA, 2-MTA, HPA, and Viscoat #150, #155, #158, #190, #192, #193, #220, #2000, #2100, and #2150 (manufactured by OSAKA ORGANIC CHEMICAL INDUSTRY); Light Acrylate BO-A, EC-A, DMP-A, THF-A, HOP-A, HOA-MPE, HOA-MPL, PO-A, P-200A, NP-4EA, NP-8EA, Epoxy Ester M-600A, POB-A, and OPP-EA (manufactured by KYOEISHA CHEMICAL); KAYARAD® TC110S, R-564, and R-128H (manufactured by NIPPON KAYAKU); NK Ester AMP-10G, AMP-20G, and A-LEN-10 (manufactured by SHIN-NAKAMURA CHEMICAL); FA-511A, 512A, and 513A (manufactured by Hitachi Chemical); PHE, CEA, PHE-2, PHE-4, BR-31, BR-31M, and BR-32 (manufactured by DKS); VP (manufactured by BASF); ACMO, DMAA, and DMAPAA (manufactured by Kohjin); and HRD-01 (manufactured by NIPPON SHOKUBAI).
Examples of a polyfunctional (meth)acrylic compound having two or more acryloyl groups or methacryloyl groups

are as follows, but the compound is not limited to these examples.

Trimethylolpropane di(meth)acrylate, trimethylolpropane tri(meth)acrylate, EO-modified trimethylolpropane tri(meth)acrylate, PO-modified trimethylolpropane tri(meth)acrylate, EO- and PO-modified trimethylolpropane tri(meth)acrylate, dimethylol tricyclodecane di(meth)acrylate, pentaerythritol tri(meth)acrylate, pentaerythritol tetra(meth)acrylate, ethylene glycol di(meth)acrylate, tetraethylene glycol di(meth)acrylate, polyethylene glycol di(meth) acrylate, polypropylene glycol di(meth)acrylate, 1,4-butanediol di(meth)acrylate, 1,6-hexanediol di(meth)acrylate, neopentyl glycol di(meth)acrylate, 1,9-nonanediol di(meth)acrylate, 1,10-decanediol di(meth)acrylate, 1,3-adamantanedimethanol di(meth)acrylate, tris(2-hydroxyethyl)isocyanurate tri(meth)acrylate, tris(acryloyloxy)isocyanurate, bis(hydroxymethyl)tricyclodecane di(meth)acrylate, dipentaerythritol penta(meth)acrylate, dipentaerythritol hexa(meth)acrylate, EO-modified 2,2-bis(4-((meth)acryloxy)phenyl)propane, PO-modified 2,2-bis(4-((meth)acryloxy)phenyl)propane, EO- and PO-modified 2,2-bis(4-((meth)acryloxy)phenyl)propane, o-, m-, or p-benzene di(meth)acrylate, and o-, m-, or p-xylylene di(meth)acrylate.

Examples of commercially available products of the above-described polyfunctional (meth)acrylic compounds are as follows, but the products are not limited to these examples.

Yupimer® UV SA1002 and SA2007 (manufactured by Mitsubishi Chemical); Viscoat #195, #230, #215, #260, #335HP, #295, #300, #360, #700, GPT, and 3PA (manufactured by OSAKA ORGANIC CHEMICAL INDUSTRY); Light Acrylate 4EG-A, 9EG-A, NP-A, DCP-A, BP-4EA, BP-4PA, TMP-A, PE-3A, PE-4A, and DPE-6A (manufactured by KYOEISHA CHEMICAL); KAYARAD® PET-30, TMPTA, R-604, DPHA, DPCA-20, -30, -60, and -120, HX-620, D-310, and D-330 (manufactured by NIPPON KAYAKU); ARONIX® M208, M210, M215, M220, M240, M305, M309, M310, M315, M325, and M400 (manufactured by TOAGOSEI); Ripoxy® VR-77, VR-60, and VR-90 (manufactured by Showa Highpolymer); OGSOL EA-0200 and OGSOL EA-0300 (manufactured by Osaka Gas Chemicals); and SR295 and SR355 (manufactured by Sartomer).

Note that in the above-described compound group, (meth)acrylate means acrylate or methacrylate having an alcohol residue equal to acrylate. A (meth)acryloyl group means an acryloyl group or a methacryloyl group having an alcohol residue equal to the acryloyl group. EO indicates ethylene oxide, and an EO-modified compound A indicates a compound in which a (meth)acrylic acid residue and an alcohol residue of a compound A bond via the block structure of an ethylene oxide group. Also, PO indicates a propylene oxide, and a PO-modified compound B indicates a compound in which a (meth)acrylic acid residue and an alcohol residue of a compound B bond via the block structure of a propylene oxide group.

Practical examples of the styrene-based compound are as follows, but the compound is not limited to these examples.

Alkylstyrene such as styrene, 2,4-dimethyl-$\alpha$-methylstyrene, o-methylstyrene, m-methylstyrene, p-methylstyrene, 2,4-dimethylstyrene, 2,5-dimethylstyrene, 2,6-dimethylstyrene, 3,4-dimethylstyrene, 3,5-dimethylstyrene, 2,4,6-trimethylstyrene, 2,4,5-trimethylstyrene, pentamethylstyrene, o-ethylstyrene, m-ethylstyrene, p-ethylstyrene, diethylstyrene, triethylstyrene, propylstyrene 2,4-diisopropylstyrene, butylstyrene, hexylstyrene, heptylstyrene, and octylstyrene; styrene halide such as fluorostyrene, o-chlorostyrene, m-chlorostyrene, p-chlorostyrene, o-bromostyrene, m-bromostyrene, p-bromostyrene, dibromostyrene, and iodostyrene; and a compound having a styryl group as a polymerizable functional group, such as nitrostyrene, acetylstyrene, o-methoxystyrene, m-methoxystyrene, p-methoxystyrene, o-hydroxystyrene, m-hydroxystyrene, p-hydroxystyrene, 2-vinylbiphenyl, 3-vinylbiphenyl, 4-vinylbiphenyl, 1-vinylnaphthalene, 2-vinylnaphthalene, 4-vinyl-p-terphenyl, 1-vinylanthracene, $\alpha$-methylstyrene, o-isopropenyltoluene, m-isopropenyltoluene, p-isopropenyltoluene, 2,3-dimethyl-$\alpha$-methylstyrene, 3,5-dimethyl-$\alpha$-methylstyrene, p-isopropyl-$\alpha$-methylstyrene, $\alpha$-ethylstyrene, $\alpha$-chlorostyrene, divinylbenzene, diisopropylbenzene, and divinylbiphenyl.

Practical examples of the vinyl-based compound are as follows, but the compound is not limited to these examples.

Vinylpyridine, vinylpyrrolidone, vinylcarbazole, vinyl acetate, and acrylonitrile; conjugated diene monomers such as butadiene, isoprene, and chloroprene; vinyl halide such as vinyl chloride and vinyl bromide; a compound having a vinyl group as a polymerizable functional group, for example, vinylidene halide such as vinylidene chloride, vinyl ester of organic carboxylic acid and its derivative (for example, vinyl acetate, vinyl propionate, vinyl butyrate, vinyl benzoate, and divinyl adipate), and (meth)acrylonitrile.

Note that in this specification, (meth)acrylonitrile is a general term for acrylonitrile and methacrylonitrile.

Examples of the allylic compound are as follows, but the compound is not limited to these examples.

Allyl acetate, allyl benzoate, diallyl adipate, diallyl terephthalate, diallyl isophthalate, and diallyl phthalate.

Examples of the fumaric compound are as follows, but the compound is not limited to these examples.

Dimethyl fumarate, diethyl fumarate, diisopropyl fumarate, di-sec-butyl fumarate, diisobutyl fumarate, di-n-butyl fumarate, di-2-ethylhexyl fumarate, and dibenzyl fumarate.

Examples of the maleic compound are as follows, but the compound is not limited to these examples.

Dimethyl maleate, diethyl maleate, diisopropyl maleate, di-sec-butyl maleate, diisobutyl maleate, di-n-butyl maleate, di-2-ethylhexyl maleate, and dibenzyl maleate.

Other examples of the radical polymerizable compound are as follows, but the compound is not limited to these examples.

Dialkylester of itaconic acid and its derivative (for example, dimethyl itaconate, diethyl itaconate, diisopropyl itaconate, di-sec-butyl itaconate, diisobutyl itaconate, di-n-butyl itaconate, di-2-ethylhexyl itaconate, and dibenzyl itaconate), an N-vinylamide derivative of organic carboxylic acid (for example, N-methyl-N-vinylacetamide), and maleimide and its derivative (for example, N-phenylmaleimide and N-cyclohexylmaleimide).

If the component (a) is formed by a plurality of types of compounds having one or more polymerizable functional groups, both a monofunctional polymerizable compound and a polyfunctional polymerizable compound are preferably included. The ratio of the polyfunctional polymerizable compound in the component (a) is preferably 20 wt% or more, more preferably 25 wt% or more, and particularly preferably 40 wt% or more. This is because if a monofunctional compound and a polyfunctional compound are combined, a cured film having well-balanced performance, for example, a high mechanical strength, a high dry etching resistance, and a high heat resistance can be obtained.

The film forming method according to the embodiment of the present invention requires a few milliseconds to a few hundreds of seconds until droplets of the curable composition (A) discretely arranged on a substrate bond to each other and form a practically continuous liquid film, so a waiting step (to be described later) may be necessary. In this waiting step, the solvent (d) is volatilized, but the polymerizable compound (a) must not be volatilized. Accordingly, all the boiling points of one or more types of polymerizable compounds that can be included in the polymerizable compound (a) at normal pressure are preferably 250°C or more, more preferably 300°C or more, and further preferably 350°C or more. Also, to obtain a high dry etching resistance and a high heat resistance, the cured film of the curable composition (A) preferably contains at least a compound having a cyclic structure such as an aromatic structure, an aromatic heterocyclic structure, or an alicyclic structure. Note that the normal pressure can be 1 atm (atmospheric pressure).

The boiling point of the polymerizable compound (a) is roughly correlated with the molecular weight. Therefore, all the molecular weights of one or more types of polymerizable compounds that can be included in the polymerizable compound (a) are preferably 200 or more, more preferably 240 or more, and further preferably 250 or more. However, even when the molecular weight is 200 or less, the compound is preferably usable as the polymerizable compound (a) according to the embodiment of the present invention if the boiling point is 250°C or more. That is, the boiling points of one or more types of polymerizable compounds included in the polymerizable compound (a) are preferably 250°C or more at normal pressure.

In addition, the vapor pressure at 80°C of the polymerizable compound (a) is preferably 0.001 mmHg or less. If the polymerizable compound (a) includes one or more types of polymerizable compounds, the vapor pressures of the one or more types of polymerizable compounds at 80°C are preferably 0.001 mmHg or less. This is so because, although it is favorable to heat the curable composition when accelerating volatilization of the solvent (d) (to be described later), it is necessary to suppress volatilization of the polymerizable compound (a) during heating.

Note that the boiling point and the vapor pressure of each of various kinds of organic compounds at normal pressure can be calculated by, for example, Hansen Solubility Parameters in Practice (HSPiP) 5th Edition. 5.3.04.

<Ohnishi Parameter (OP) of Component (a)>

It is known that a dry etching rate V of an organic compound, a number N of all atoms in the organic compound, a number $N_C$ of all carbon atoms in a composition, and a number $N_O$ of all oxygen atoms in the composition have a relationship of equation (1) below (NPL 2).

$$V \propto N/(N_C - N_o) \qquad ...(1)$$

where $N/(N_C - N_O)$ is also called "Ohnishi Parameter" (to be referred to as "OP" hereinafter). For example, PTL 3 describes a technique of obtaining a photocurable composition having a high dry etching resistance by using a polymerizable compound having a small OP.

Equation (1) indicates that an organic compound having many oxygen atoms in a molecule or having few aromatic ring structures or alicyclic structures has a large OP and a high dry etching rate.

In the curable composition (A) according to the embodiment of the present invention, the OP of the component (a) is 1.80 or more and 4.00 or less. The OP of the component (a) is more preferably 2.00 or more and 3.50 or less, and particularly preferably 2.40 or more and 3.00 or less. When the OP of the component (a) is 4.00 or less, the cured film of the curable composition (A) has a high dry etching resistance. When the OP of the component (a) is 1.80 or more, the cured film of the curable composition (A) can easily be removed after the underlayer is processed by using the cured film of the curable composition (A). When the component (a) is formed by a plurality of types polymerizable compounds $a_1, a_2, ..., a_n$, the OP can be calculated as a weighted average value (molar fraction weighted average value) based on the molar fraction as indicated by equation (2) below. That is, if the component (a) contains one or more types of polymerizable compounds,

the OP of the component (a) can be calculated as the molar fraction weighted average value of an $N/(N_c-N_o)$ value of each molecule of the one or more types of polymerizable compounds.

$$OP = \sum_{i=n} n_i OP_i = n_1 OP_1 + n_2 OP_2 + \cdots + n_n OP_n \quad \ldots(2)$$

Where $OP_n$ is the OP of the component $a_n$, and $n_n$ is the molar fraction occupied by the component $a_n$ in the entire component (a).

To set the OP of the component (a) to 1.80 or more and 2.70 or less, a compound (a-1) having two or more cyclic structures, in which at least one of the cyclic structures is an aromatic structure or an aromatic heterocyclic structure, is preferably contained at least as the component (a).

<Compound (a-1): Polymerizable Compound Having Aromatic Structure, Aromatic Heterocyclic Structure, or Alicyclic Structure>

The polymerizable compound (a) according to the embodiment of the present invention may contain a polymerizable compound (a-1) having an aromatic structure, an aromatic heterocyclic structure, or an alicyclic structure. Also, the ratio of the component (a-1) in the component (a) is preferably 65 wt% or more. When the ratio of the component (a-1) is 65 wt% or more, the OP can be suppressed to 2.70 or less.

Examples of the cyclic structure are an aromatic structure, an aromatic heterocyclic structure, and an alicyclic structure.

The carbon number of the aromatic structure is preferably 6 to 22, more preferably 6 to 18, and further preferably 6 to 10. Practical examples of the aromatic ring are as follows.

A benzene ring, a naphthalene ring, an anthracene ring, a phenanthrene ring, a phenalene ring, a fluorene ring, a benzocyclooctene ring, an acenaphthylene ring, a biphenylene ring, an indene ring, an indane ring, a triphenylene ring, a pyrene ring, a chrysene ring, a perylene ring, and a tetrahydronaphthalene ring.

Note that, of the above-described aromatic rings, a benzene ring or a naphthalene ring is preferable, and a benzene ring is more preferable. The aromatic ring can have a structure in which a plurality of rings are connected. Examples are a biphenyl ring and a bisphenyl ring.

The carbon number of the aromatic heterocyclic structure is preferably 1 to 12, more preferably 1 to 6, and further preferably 1 to 5. Practical examples of the aromatic heterocycle are as follows.

A thiophene ring, a furan ring, a pyrole ring, an imidazole ring, a pyrazole ring, a triazole ring, a tetrazole ring, a thiazole ring, a thiadiazole ring, an oxadiazole ring, an oxazole ring, a pyridine ring, a pyrazine ring, a pyrimidine ring, pyridazine ring, an isoindole ring, an indole ring, an indazole ring, a purine ring, a quinolizine ring, an isoquinoline ring, a quinoline ring, a phthalazine ring, a naphthyridine ring, a quinoxaline ring, a quinazoline ring, a cinnoline ring, a carbazole ring, an acridine ring, a phenazine ring, a phenothiazine ring, a phenoxathiine ring, and a phenoxazine ring.

The carbon number of the alicyclic structure is preferably 3 or more, more preferably 4 or more, and further preferably 6 or more. In addition, the carbon number of the alicyclic structure is preferably 22 or less, more preferably 18 or less, further preferably 6 or less, and still further preferably 5 or less. Practical examples are as follows.

A cyclopropane ring, a cyclobutane ring, a cyclobutene ring, a cyclopentane ring, a cyclohexane ring, a cyclohexene ring, a cycloheptane ring, a cyclooctane ring, a dicyclopentadiene ring, a spirodecane ring, a spirononane ring, a tetrahydro dicyclopentadiene ring, an octahydronaphthalene ring, a decahydronaphthalene ring, a hexahydroindane ring, a bornane ring, a norbornane ring, a norbornene ring, an isobornane ring, a tricyclodecane ring, a tetracyclododecane ring, and an adamantane ring.

Practical examples of the polymerizable compound (a-1) having a boiling point of 250°C or more are as follows, but the compound is not limited to these examples.

3-phenoxybenzyl acrylate (mPhOBzA, OP = 2.54, boiling point = 367.4°C, 80°C vapor pressure = 0.0004 mmHg, molecular weight = 254.3)

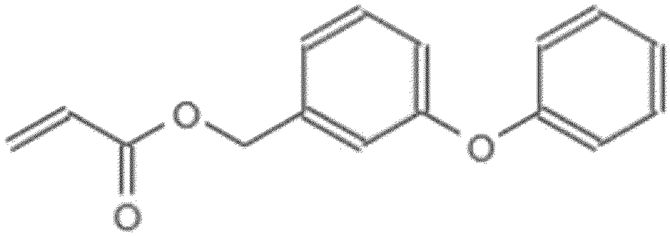

1-naphthyl acrylate (NaA, OP = 2.27, boiling point = 317°C, 80°C vapor pressure = 0.0422 mmHg, molecular weight = 198)

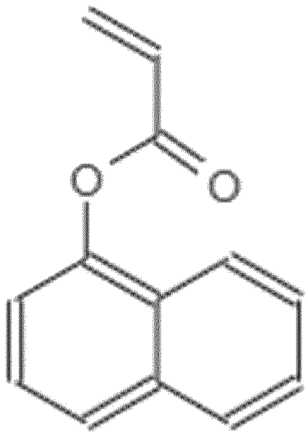

2-phenylphenoxyethyl acrylate (PhPhOEA, OP = 2.57, boiling point = 364.2°C, 80°C vapor pressure = 0.0006 mmHg, molecular weight = 268.3)

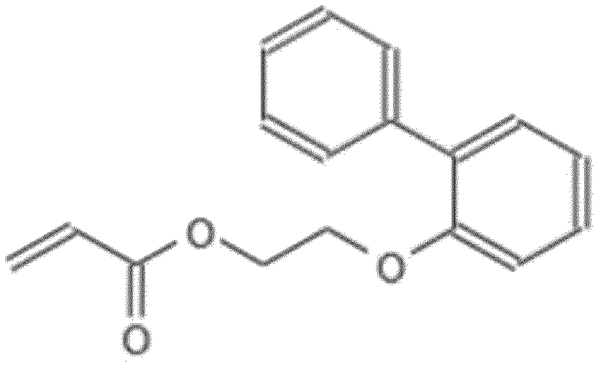

1-naphthylmethyl acrylate (Na1MA, OP = 2.33, boiling point = 342.1°C, 80°C vapor pressure = 0.042 mmHg, molecular weight = 212.2)

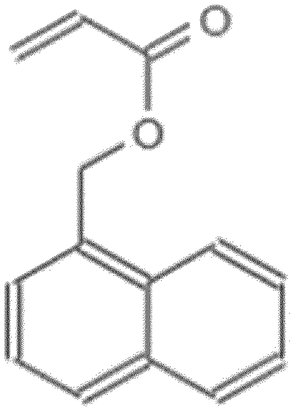

2-naphthylmethyl acrylate (Na2MA, OP = 2.33, boiling point = 342.1°C, 80°C vapor pressure = 0.042 mmHg, molecular weight = 212.2)

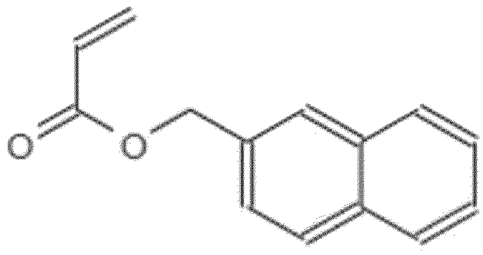

DPhPA indicated by the formula below (OP = 2.38, boiling point = 354.5°C, 80°C vapor pressure = 0.0022 mmHg, molecular weight = 266.3)

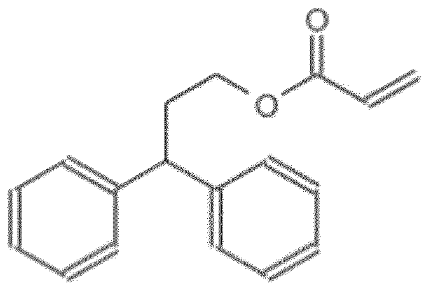

PhBzA indicated by the formula below (OP = 2.29, boiling point = 350.4°C, 80°C vapor pressure = 0.0022 mmHg, molecular weight = 238.3)

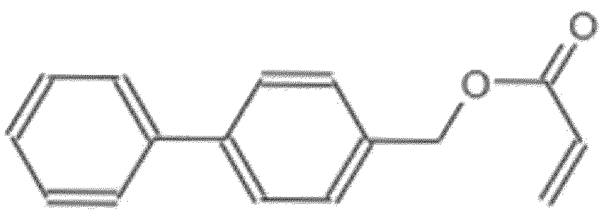

FLMA indicated by the formula below (OP = 2.20, boiling point = 349.3°C, 80°C vapor pressure = 0.0018 mmHg, molecular weight = 250.3)

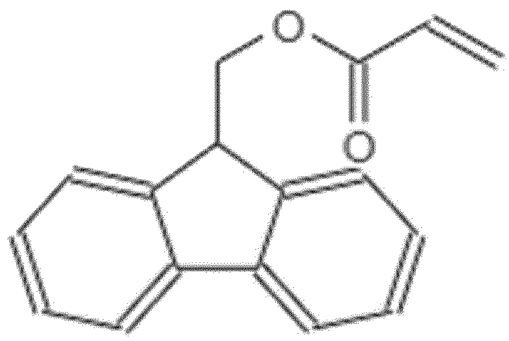

ATMA indicated by the formula below (OP = 2.13, boiling point = 414.9°C, 80°C vapor pressure = 0.0001 mmHg, molecular weight = 262.3)

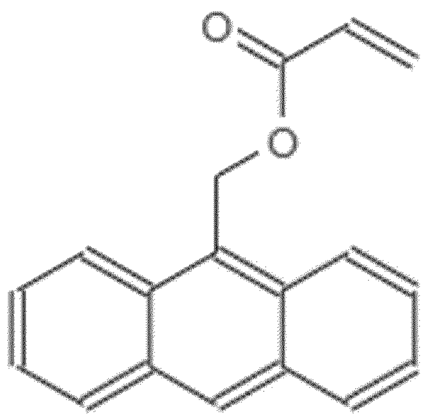

DNaMA indicated by the formula below (OP = 2.00, boiling point = 489.4°C, 80°C vapor pressure < 0.0001 mmHg, molecular weight = 338.4)

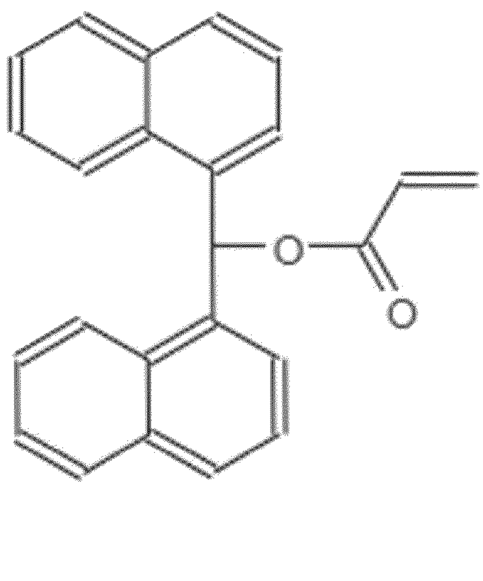

BPh44DA indicated by the formula below (OP = 2.63, boiling point = 444°C, 80°C vapor pressure < 0.0001 mmHg, molecular weight = 322.3)

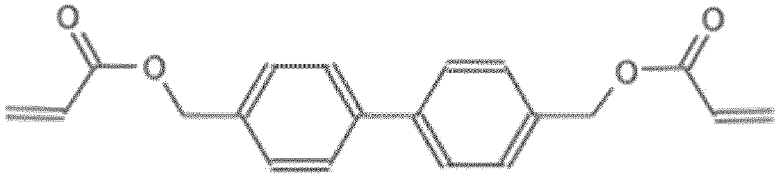

BPh43DA indicated by the formula below (OP = 2.63, boiling point = 439.5°C, 80°C vapor pressure < 0.0001 mmHg, molecular weight = 322.3)

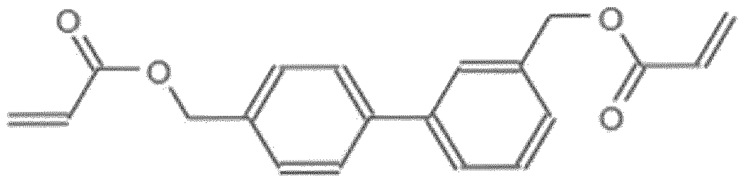

DPhEDA indicated by the formula below (OP = 2.63, boiling point = 410°C, 80°C vapor pressure < 0.0001 mmHg, molecular weight = 322.3)

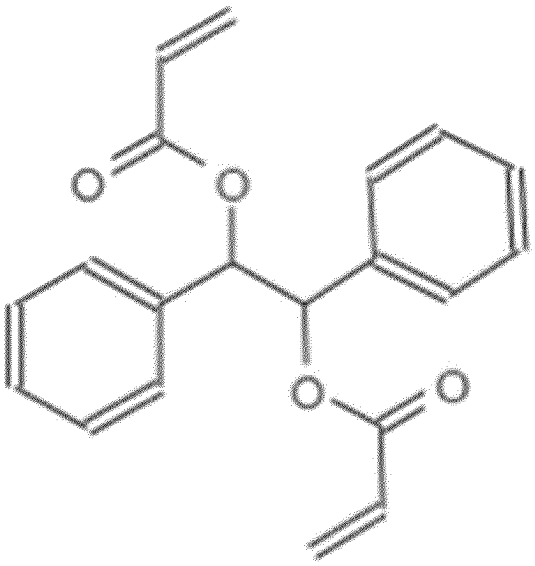

BPMDA indicated by the formula below (OP = 2.68, boiling point = 465.7°C, 80°C vapor pressure < 0.0001 mmHg, molecular weight = 364.4)

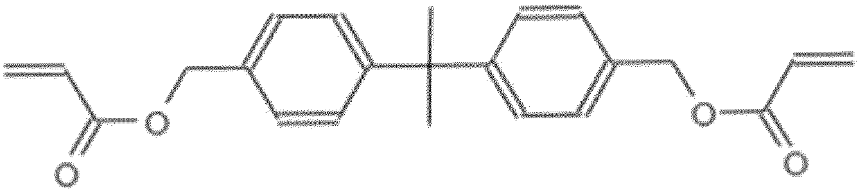

Na13MDA indicated by the formula below (OP = 2.71, boiling point = 438.8°C, 80°C vapor pressure < 0.0001 mmHg, molecular weight = 296.3)

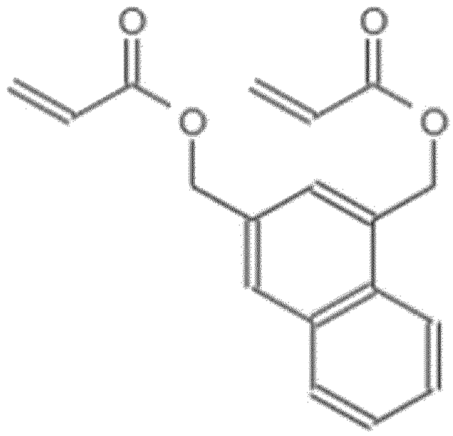

Formula below (a-1-1) (OP = 2.40, boiling point = 333.4°C, 80°C vapor pressure = 0.0181 mmHg, molecular weight = 199.2)

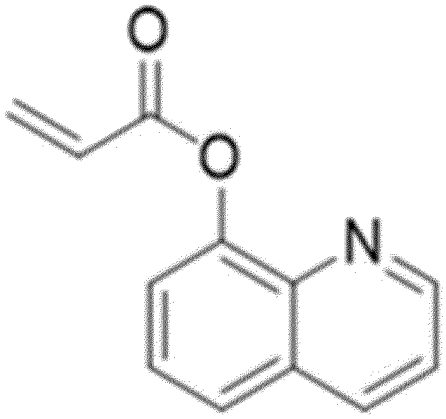

Formula below (a-1-2) (OP = 2.40, boiling point = 333.4°C, 80°C vapor pressure = 0.0181 mmHg, molecular weight = 199.2)

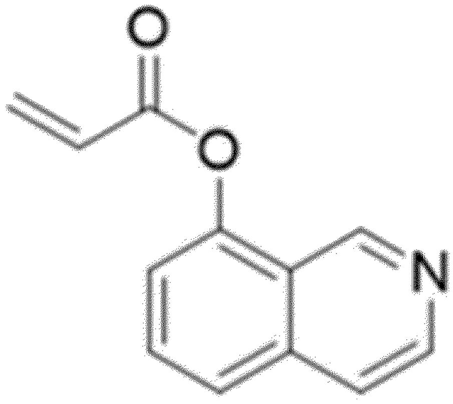

Formula below (a-1-3) (OP = 1.86, boiling point = 369.5°C, 80°C vapor pressure = 0.0053 mmHg, molecular weight = 193.3)

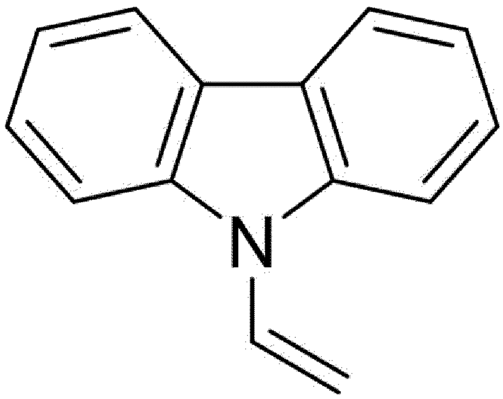

Formula below (a-1-4) (OP = 2.85, boiling point = 438.8°C, 80°C vapor pressure < 0.0001 mmHg, molecular weight = 296.3)

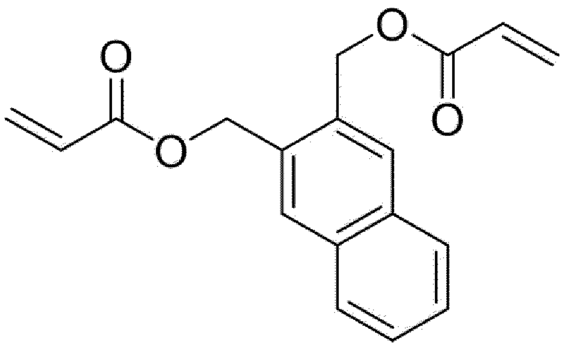

Formula below (a-1-5) (OP = 2.71, boiling point = 438.8°C, 80°C vapor pressure < 0.0001 mmHg, molecular weight = 296.3)

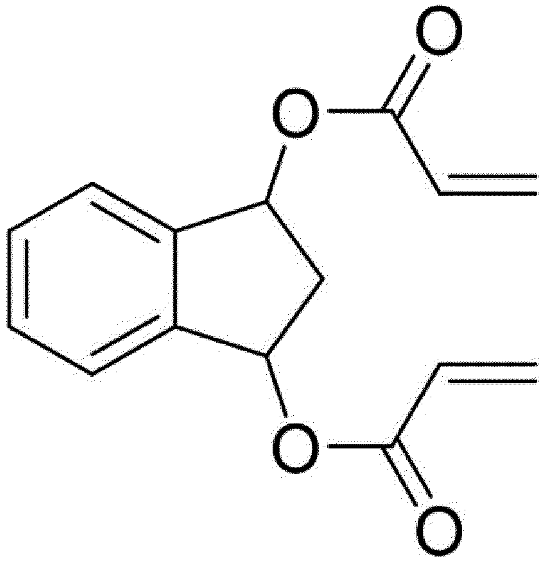

Formula below (a-1-6) (OP = 2.87, boiling point = 421.0°C, 80°C vapor pressure < 0.0001 mmHg, molecular weight = 338.4)

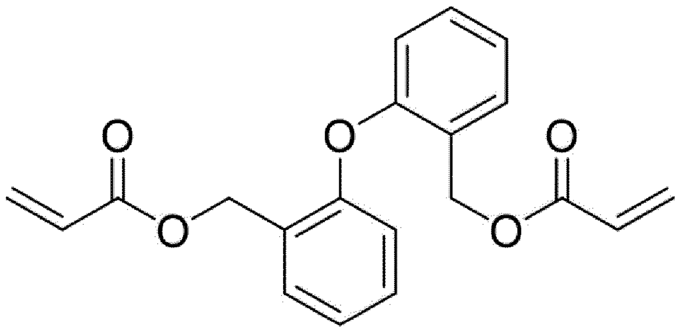

Formula below (a-1-7) (OP = 2.87, boiling point = 465.2°C, 80°C vapor pressure < 0.0001 mmHg, molecular weight = 338.4)

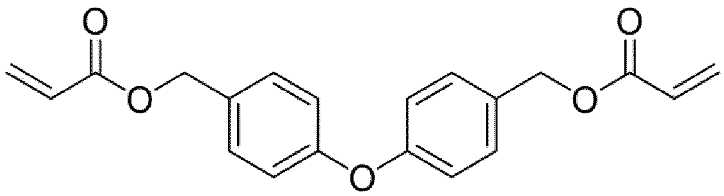

Formula below (a-1-8) (OP = 2.68, boiling point = 465.7°C, 80°C vapor pressure < 0.0001 mmHg, molecular weight = 364.4)

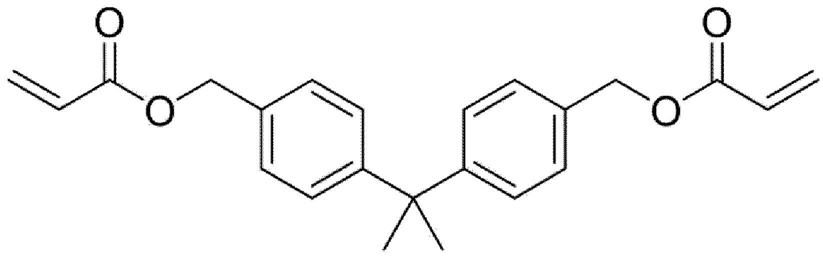

Formula below (a-1-9) (OP = 2.50, boiling point = 433.1°C, 80°C vapor pressure < 0.0001 mmHg, molecular weight = 320.3)

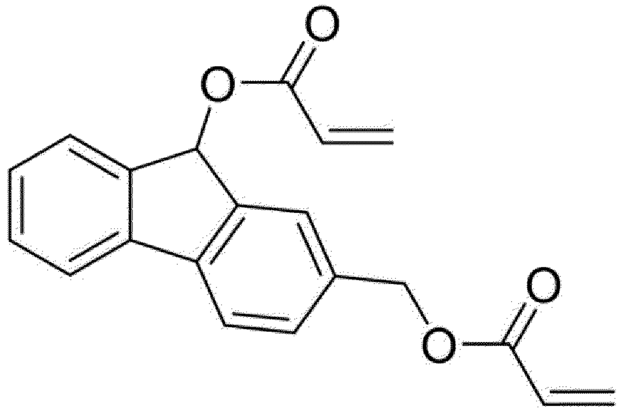

Formula below (a-1-10) (OP = 2.64, boiling point = 468.1°C, 80°C vapor pressure < 0.0001 mmHg, molecular weight = 326.4)

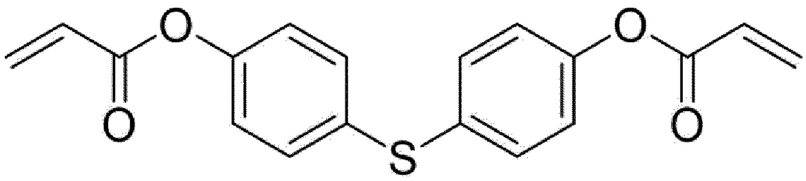

Formula below (a-1-11) (OP = 3.25, boiling point = 553.4°C, 80°C vapor pressure < 0.0001 mmHg, molecular weight = 358.4)

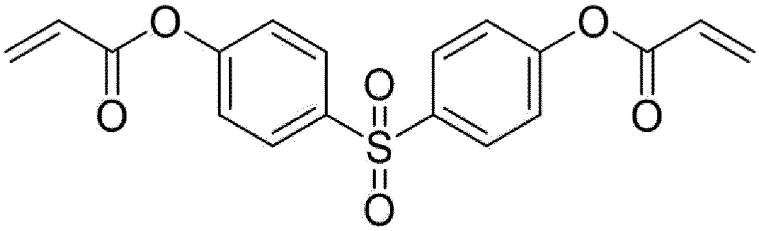

Formula below (a-1-12) (OP = 2.63, boiling point = 443.9°C, 80°C vapor pressure < 0.0001 mmHg, molecular weight = 322.4)

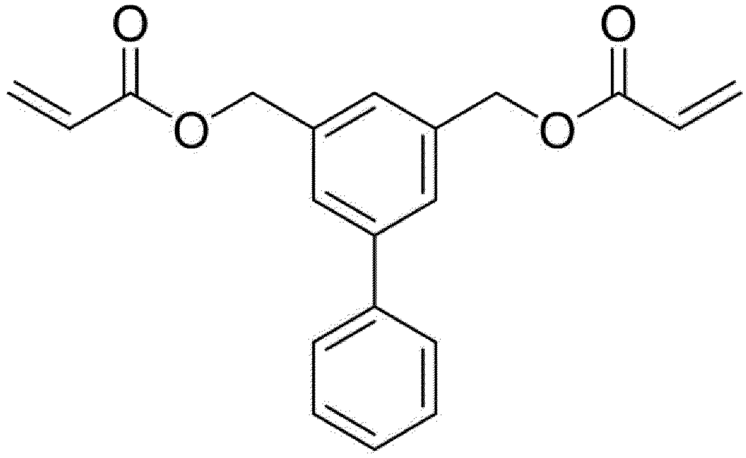

Formula below (a-1-13) (OP = 2.89, boiling point = 509.3°C, 80°C vapor pressure < 0.0001 mmHg, molecular weight = 406.4)

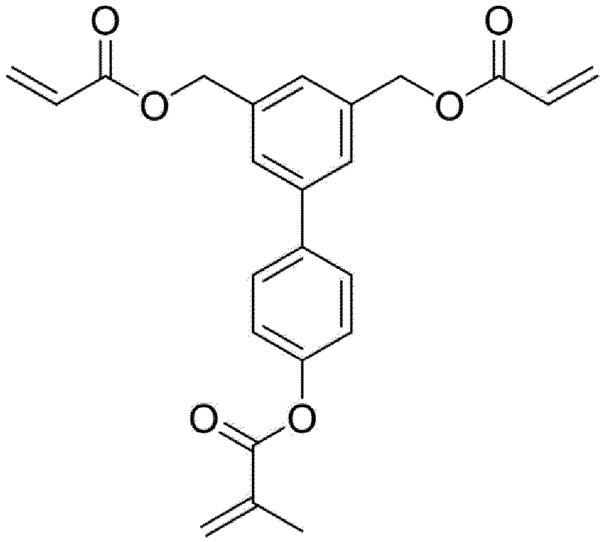

Formula below (a-1-14) (OP = 2.63, boiling point = 450.0°C, 80°C vapor pressure < 0.0001 mmHg, molecular weight = 322.4)

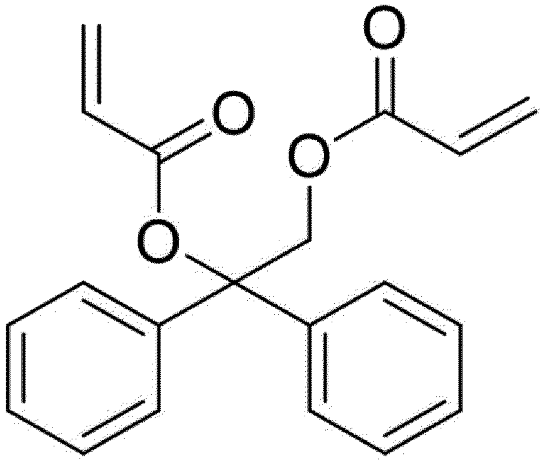

Formula below (a-1-15) (OP = 3.00, boiling point = 476.5°C, 80°C vapor pressure < 0.0001 mmHg, molecular weight = 366.4)

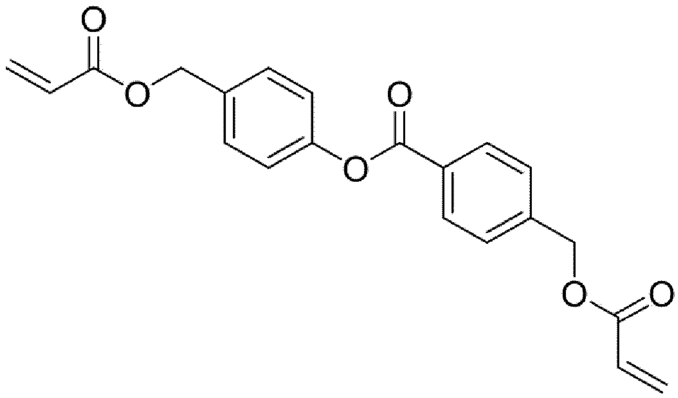

Formula below (a-1-16) (OP = 2.68, boiling point = 447.4°C, 80°C vapor pressure < 0.0001 mmHg, molecular weight = 364.4)

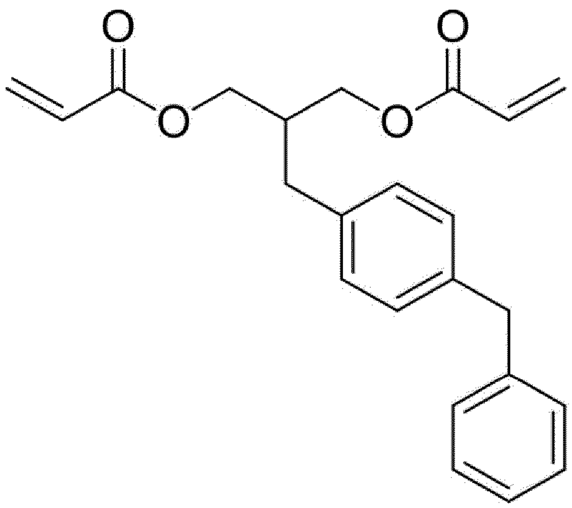

Formula below (a-1-17) (OP = 2.36, boiling point = 543.8°C, 80°C vapor pressure < 0.0001 mmHg, molecular weight = 398.5)

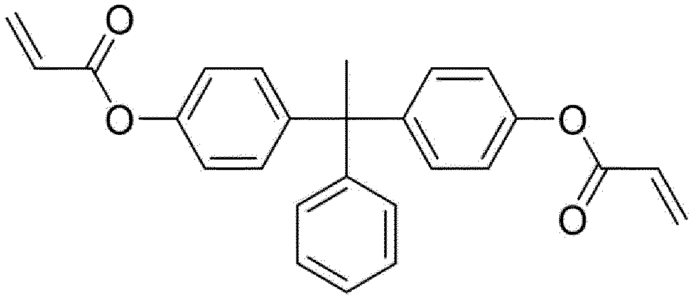

Formula below (a-1-18) (OP = 3.27, boiling point = 526.9°C, 80°C vapor pressure < 0.0001 mmHg, molecular weight = 396.4)

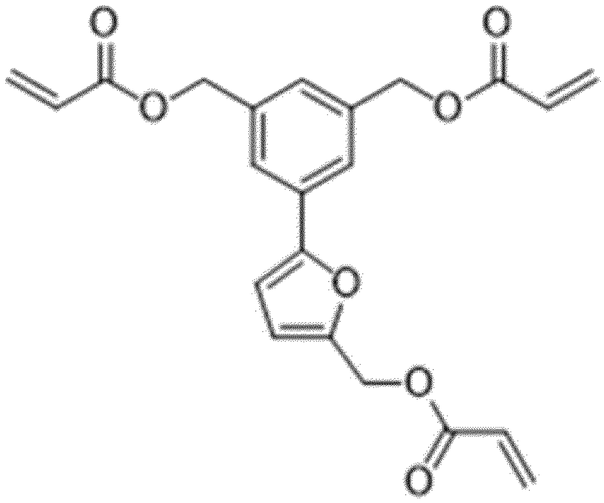

Formula below (a-1-19) (OP = 2.71, boiling point = 333.7°C, 80°C vapor pressure = 0.0302 mmHg, molecular weight = 244.3)

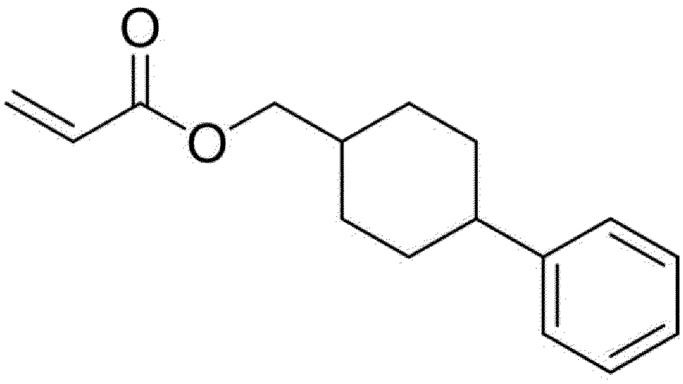

Formula below (a-1-20) (OP = 2.73, boiling point = 333.7°C, 80°C vapor pressure = 0.0134 mmHg, molecular weight = 258.3)

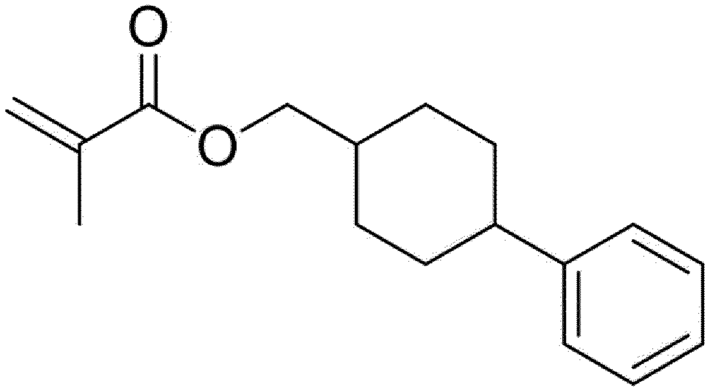

Formula below (a-1-21) (OP = 2.71, boiling point = 319.2°C, 80°C vapor pressure = 0.0566 mmHg, molecular weight = 262.3)

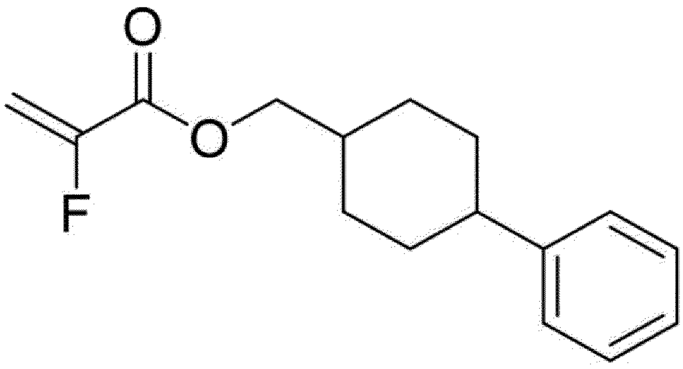

Formula below (a-1-22) (OP = 2.71, boiling point = 336.9°C, 80°C vapor pressure = 0.0055 mmHg, molecular weight = 244.3)

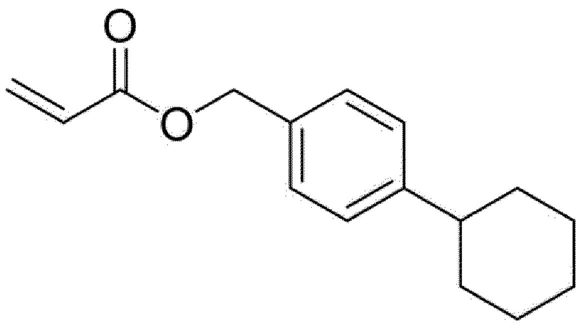

Formula below (a-1-23) (OP = 3.00, boiling point = 370.9°C, 80°C vapor pressure = 0.0021 mmHg, molecular weight = 274.4)

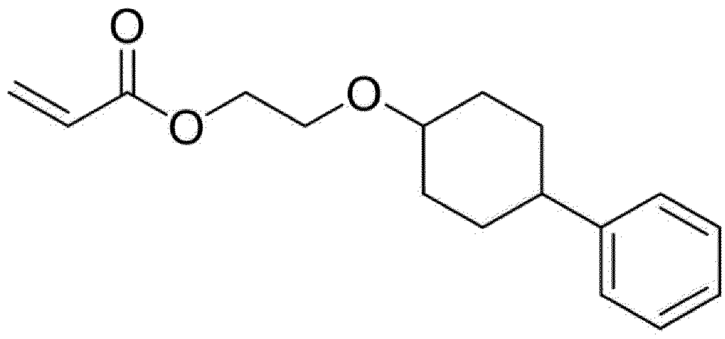

Formula below (a-1-24) (OP = 3.00, boiling point = 376.4°C, 80°C vapor pressure = 0.0005 mmHg, molecular weight = 274.4)

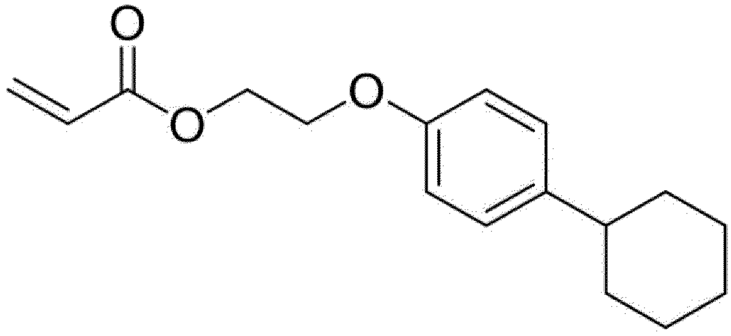

Formula below (a-1-25) (OP = 3.00, boiling point = 379.4°C, 80°C vapor pressure = 0.0002 mmHg, molecular weight = 288.4)

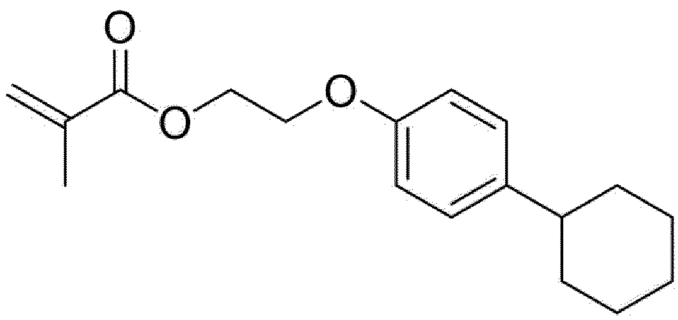

Formula below (a-1-26) (OP = 2.33, boiling point = 360.8°C, 80°C vapor pressure = 0.0006 mmHg, molecular weight = 252.3)

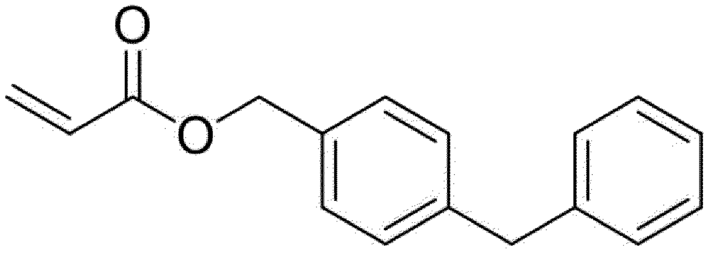

Formula below (a-1-27) (OP = 2.54, boiling point = 371.5°C, 80°C vapor pressure = 0.0003 mmHg, molecular weight = 254.3)

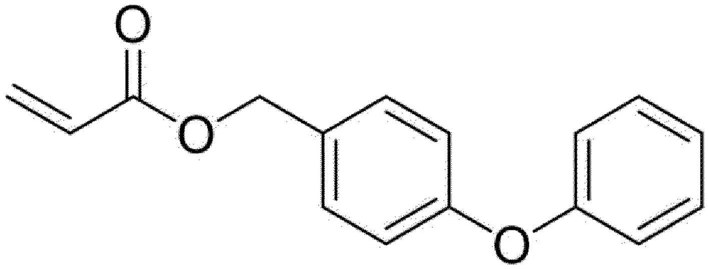

Formula below (a-1-28) (OP = 2.57, boiling point = 381.2°C, 80°C vapor pressure = 0.0001 mmHg, molecular weight = 268.3)

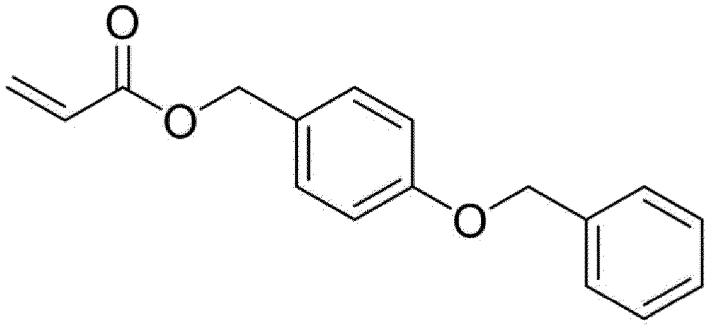

Formula below (a-1-29) (OP = 2.57, boiling point = 381.8°C, 80°C vapor pressure = 0.0004 mmHg, molecular weight = 268.3)

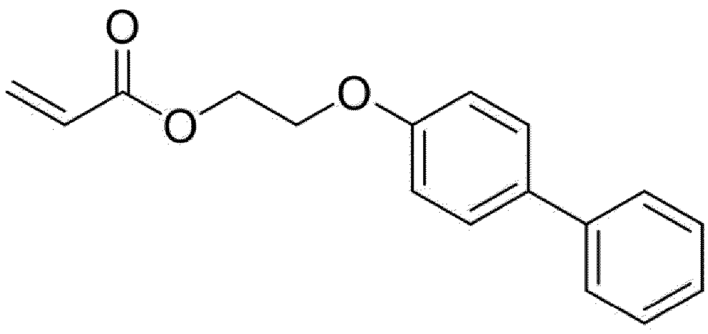

Formula below (a-1-30) (OP = 2.50, boiling point = 487.4°C, 80°C vapor pressure < 0.0001 mmHg, molecular weight = 374.4)

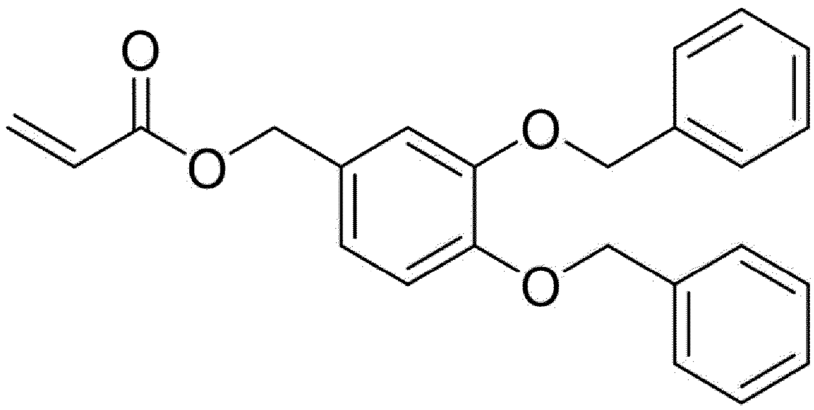

Formula below (a-1-31) (OP = 2.67, boiling point = 417.2°C, 80°C vapor pressure < 0.0001 mmHg, molecular weight = 268.3)

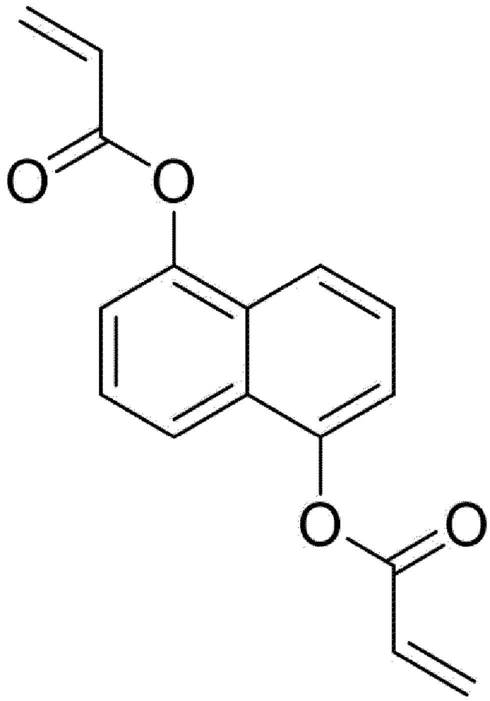

Formula below (a-1-32) (OP = 2.67, boiling point = 417.2°C, 80°C vapor pressure < 0.0001 mmHg, molecular weight = 268.3)

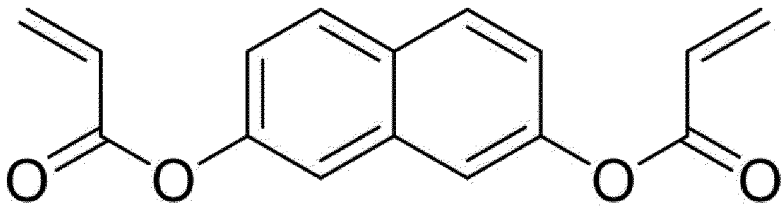

Formula below (a-1-33) (OP = 2.67, boiling point = 417.2°C, 80°C vapor pressure < 0.0001 mmHg, molecular weight = 268.3)

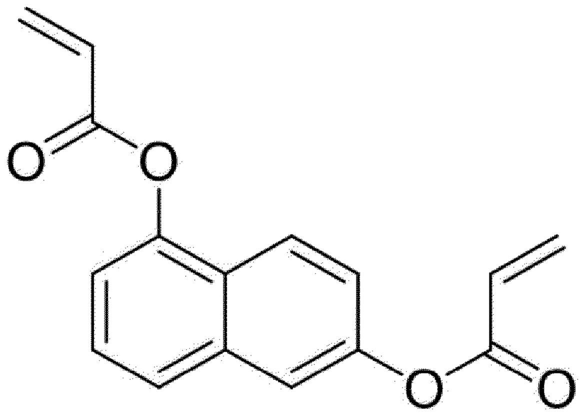

Formula below (a-1-34) (OP = 2.67, boiling point = 417.2°C, 80°C vapor pressure < 0.0001 mmHg, molecular weight = 268.3)

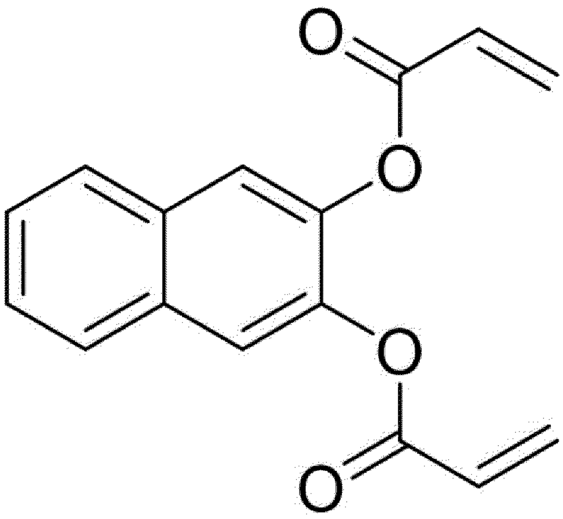

Formula below (a-1-35) (OP = 2.71, boiling point = 438.8°C, 80°C vapor pressure < 0.0001 mmHg, molecular weight = 296.3)

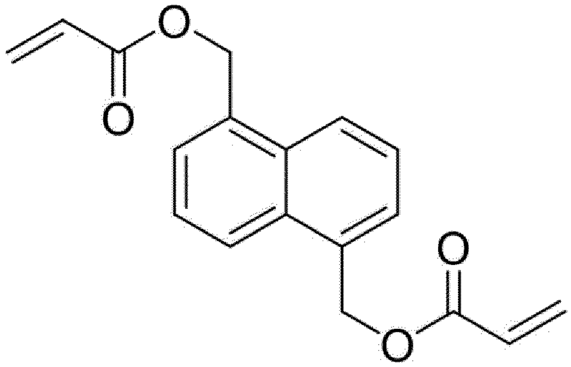

<Compound (a-2): Polymerizable Compound Containing At Least Si Atoms>

The polymerizable compound (a) according to the embodiment of the present invention may contain a polymerizable compound (a-2) containing at least Si atoms. Furthermore, if the polymerizable compound (a) contains the polymerizable compound (a-2), the curable composition (A) from which the solvent (d) is removed preferably contains Si atoms of 10 wt% or more with respect to the whole curable composition (A).

As an example of the polymerizable compound (a-2) containing at least Si atoms, it may have a linear structure or a branched structure. For example, as cyclic siloxane compounds, the following structures can be used. An example of a polymerizable functional group in a group Q having a polymerizable functional group is a radical polymerizable functional group. Practical examples of the radical polymerizable functional group are a (meth)acrylic group, a (meth)acrylamide group, a vinylbenzene group, an allyl ether group, a vinylether group, and a maleimide group. The group Q having a polymerizable functional group need only be a group having the above-described polymerizable functional group.

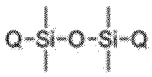
a-1

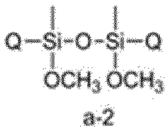
a-2

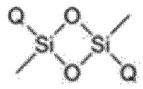
a-3

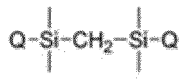
a-4

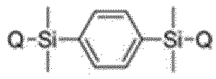
a-5

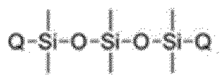
a-6

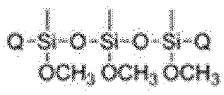
a-7

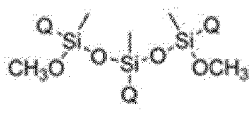
a-8

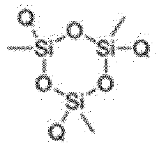
a-9

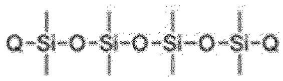
a-10

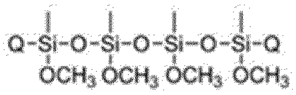
a-11

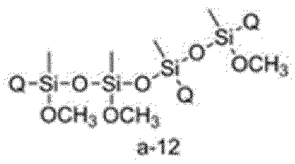
a-12

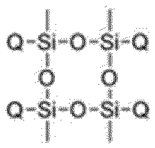
a-13

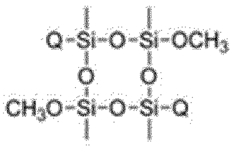
a-14

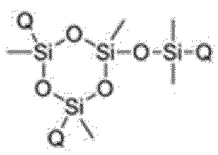
a-15

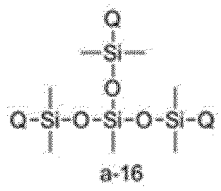
a-16

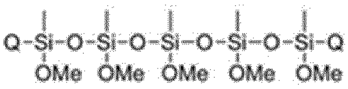

a-17

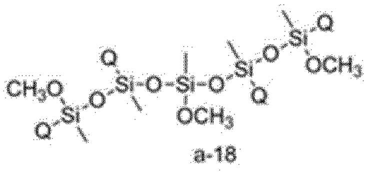

a-18

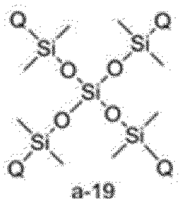

a-19

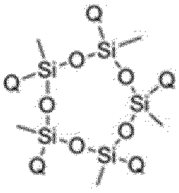

a-20

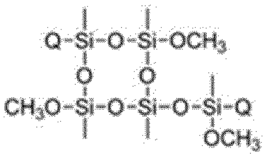

a-21

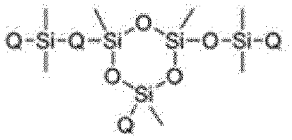

a-22

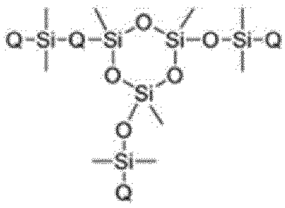

a-26

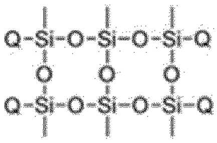

a-23

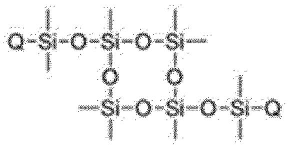

a-24

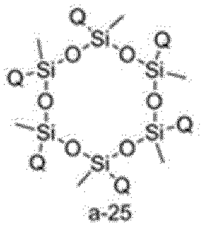

a-25

Other examples of the polymerizable compound (a-2) are a silsesquioxane skeleton as indicated by chemical formula (I) below and a silicone skeleton as indicated by chemical formula (II). In chemical formula (I), m + n =8 (8 ≥ m ≥ 1), and $R_1$ is a bivalent organic group. Additionally, in chemical formula (II), A, B, $R_2$, and $R_3$ are independently an alkyl group, a cycloalkyl group, an alkoxy group, a phenyl group, and hydroxyl group whose carbon number is 1 to 6, t is an integer of 1 to 3, and at least one of A and B is a polymerizable functional group.

(I)

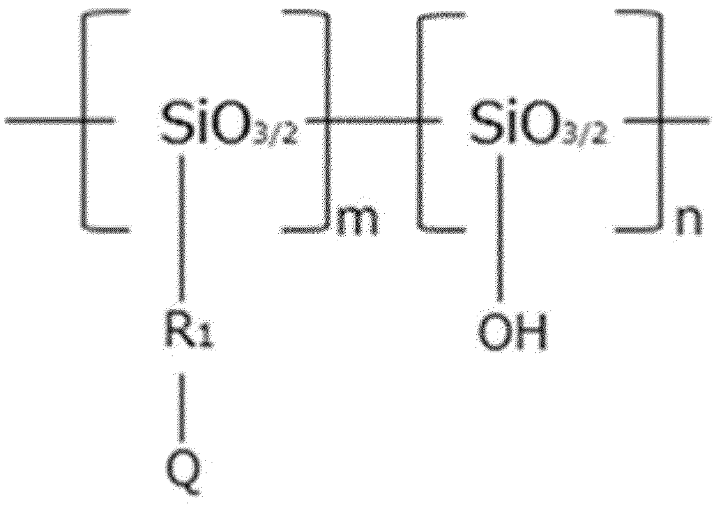

(II)

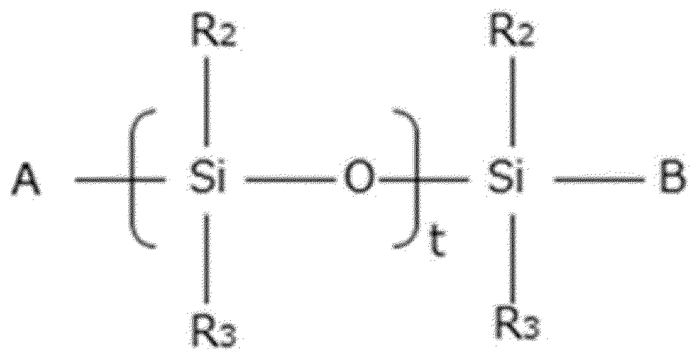

An example of a polymerizable functional group in groups Q, A, and B having a polymerizable functional group is a radical polymerizable functional group. Detailed examples of the radical polymerizable functional group are a (meth)acrylate-based compound, a (meth)acrylamide-based compound, a vinylbenzene-based compound, an aryl ether-based compound, a vinyl ether-based compound, and a maleimide-based compound. The group Q having a polymerizable functional group can be a group having the above-described polymerizable functional group.

A silicon-containing (meth)acrylate-based compound is a compound having one or more acryloyl groups or methacryloyl groups. Examples of a silicon-containing monofunctional (meth)acrylate-based compound having one acryloyl group or methacryloyl group are as follows, but the compound is not limited to these examples.

(2-acryloylethoxy)trimethylsilane,
N-(3-acryloyl-2-hydroxypropyl)-3-aminopropyltriethoxysilane,
acryloxymethyltrimethoxysilane,
(acryloxymethyl)phenethyltrimethoxysilane,
acryloxymethyltrimethylsilane,
(3-acryloxypropyl)dimethylmethoxysilane,
(3-acryloxypropyl)methylbis(trimethylsiloxy)silane,
(3-acryloxypropyl)methyldichlorosilane,
(3-acryloxypropyl)methyldiethoxysilane,
(3-acryloxypropyl)methyldimethoxysilane,
(3-acryloxypropyl)trichlorosilane,
(3-acryloxypropyl)trimethoxysilane,
(3-acryloxypropyl)tris(trimethylsiloxy)silane,
acryloxytriisopropylsilane,
acryloxytrimethylsilane,
methacryloxymethyltrimethoxysilane,
O-(methacryloxyethoxy)carbamoylpropylmethyldimethoxysilane,
(methacryloxymethyl)bis(trimethylsiloxy)methylsilane,
N-(3-methacryloyl-2-hydroxypropyl)-3-aminopropyltriethoxysilane,
(methacryloxymethyl)methyldimethoxysilane,
(methacryloxymethyl)methyldiethoxysilane,
methacryloxymethylmethyltriethoxysilane,
methacryloxypropyltrimethoxysilane,
methacryloylpropyltriisopropoxysilane,
O-(methacryloxyethyl)-N-(triethoxysilylpropyl) carbamate,
methacryloxypropylmethyldimethoxysilane,
methacryloxypropylmethyldiethoxysilane,
methacryloxypropyldimethylmethoxysilane,
methacryloxypropyldimethylethoxysilane,
(methacryloxymethyl)dimethylethoxysilane,
methacryloxypropyltriethoxysilane,
methacryloxypropylsilatrane,
methacryloxypentamethyldisiloxane,
(methacryloxymethyl)phenyldimethylsilane,

methacryloxytrimethylsilane,
methacryloxymethyltrimethylsilane,
(3-methacryloxy-2-hydroxypropoxypropyl)methyl bis(trimethylsiloxy)silane,
methacryloxypropylpentamethyldisiloxane,
O-(methacryloxyethyl)-3-[bis(trimethylsiloxy)methylsilyl]propylcarbamate,
methacryloxymethyltris(trimethylsiloxy)silane,
methacryloxyethoxytrimethylsilane,
(3-methacryloxy-2-hydroxypropoxypropyl)methyl bis(trimethylsiloxy)silane,
methacryloxypropyltris(vinyldimethylsiloxy)silane,
methacryloxypropyltris(trimethylsiloxy)silane,
3-methacryloxypropyltriacetoxysilane,
methacryloxypropylmethyldichlorosilane,
methacryloxypropyltrichlorosilane,
3-methacryloxypropylbis(trimethylsiloxy)methylsilane,
3-methacryloxypropyldimethylchlorosilane,
O-methacryloxy(polyethyleneoxy)trimethylsilane,
poly(methacryloxypropylsilsesquioxane),
methacryloxypropylheptaisobutyl-T8-silsesquioxane, and
methacryloxypropyltris(trimethylsiloxy)silane

Examples of the commercially available products of the above-described silicon-containing monofunctional (meth)acrylic compounds are as follows, but the products are not limited to these examples.
SIA0160.0, SIA0180.0, SIA0182.0, SIA0184.0, SIA0186.0, SIA0190.0, SIA0194.0, SIA0196.0, SIA0197.0, SIA0198.0, SIA0199.0, SIA0200.0, SIA0200.A1, SIA0210.0, SIA0315.0, SIA0320.0, SIM6483.0, SIM6487.5, SIM6480.76, SIM6481.2, SIM6486.1, SIM6481.1, SIM6481.46, SIM6481.43, SIM6482.0, SIM6487.4, SIM6487.35, SIM6480.8, SIM6486.9, SIM6486.8, SIM6486.5, SIM6486.4, SIM6481.3, SIM6487.3, SIM6487.1, SIM6487.6, SIM6486.14, SIM6481.48, SIM6481.5, SIM6491.0, SIM6485.6, SIM6481.15, SIM6487.0, SIM6481.05, SIM6485.8, SIM6481.0, SIM6487.4LI, SIM6481.16, SIM6487.8, SIM6487.6HP, SIM6487.17, SIM6486.7, SIM6487.2, SIM6486.0, SIM6486.2, SIM6487.6-06, SIM6487.6-20, SIM6485.9, SST-R8C42, SLT-3R01, and SIM6486.65 (manufactured by GELEST), and TM-0701T, FM-0711, FM-0721, and FM-0725 (manufactured by JNC)
A silicon-containing (meth)acrylamide-based compound is a compound having one or more acrylamide groups or methacrylamide groups. Examples of a silicon-containing monofunctional (meth)acrylamide-based compound having one acrylamide group or methacrylamide group are as follows, but the compound is not limited to these examples.
3-acrylamidopropyltrimethoxysilane, and 3-acrylamidopropyltris(trimethylsiloxy)silane
Examples of the commercially available products of the above-described silicon-containing monofunctional (meth)acrylamide compounds are as follows, but the products are not limited to these examples. SIA0146.0, and SIA0150.0 (manufactured by GELEST)
Examples of a polyfunctional (meth)acrylate-based compound having two or more acryloyl groups or methacryloyl groups are as follows, but the compound is not limited to these examples.

linear polydimethylsiloxane modified on both ends with acryloxypropyl groups,
linear polydimethylsiloxane modified on both ends with methacryloxypropyl groups,
cyclic siloxane modified with multiple acryloxypropyl groups,
cyclic siloxane modified with multiple methacryloxypropyl groups,
silsesquioxane modified with multiple acryloxypropyl groups, and
silsesquioxane modified with multiple methacryloxypropyl groups

Examples of the commercially available products of the above-described silicon-containing monofunctional (meth)acrylate compounds are as follows, but the products are not limited to these examples.

SIA0200.2, SIA0200.3, SIM6487.42, DMS-R11, DMS-R05, DMS-R22, DMS-R18, DMS-R31 (manufactured by GELEST),
FM-7711, FM-7721, FM-7725 (manufactured by JNC),
X-22-2445 (manufactured by Shin-Etsu Chemical), and
AC-SQ TA-100, MAC-SQ TM-100, AC-SQ SI-20, MAC-SQ SI-20
(manufactured by TOAGOSEI)

Also, according to known literatures (for example, "Ultraviolet curable branched siloxanes as low-k dielectrics for

imprint lithography" by Ogawa et al. (https://doi.org/10.1116/1.4770051)), the following can be synthesized and/or obtained.

linear modified polydimethylsiloxane with methacryloxypropyl groups on both ends (MA-Si-12), 8-membered ring siloxane modified with four methacryloxypropyl groups (8-ring), and 10-membered ring siloxane modified with five methacryloxypropyl groups (10-ring).

The blending ratio of the component (a) in the curable composition (A) is preferably 40 wt% or more and 99 wt% or less with respect to the sum of the component (a), a component (b) (to be described later), and a component (c) (to be described later), that is, the total mass of all the components except the solvent (d). The blending ratio is more preferably 50 wt% or more and 95 wt% or less, and further preferably 60 wt% or more and 90 wt% or less. When the blending ratio of the component (a) is 40 wt% or more, the mechanical strength of the cured film of the curable composition increases. Also, when the blending ratio of the component (a) is 99 wt% or less, it is possible to increase the blending ratios of the components (b) and (c), and obtain characteristics such as a high photopolymerization rate.

At least a part of the component (a) that can include one or more types of polymerizable compounds can be polymers having a polymerizable functional group. The polymer preferably contains at least a cyclic structure such as an aromatic structure, an aromatic heterocyclic structure, or an alicyclic structure. For example, the polymer preferably contains at least one of constituent units represented by chemical formulas (1) to (6) below:

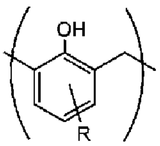
(1)

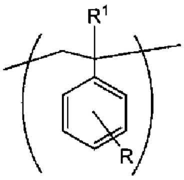
(2)

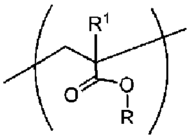
(3)

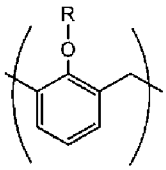
(4)

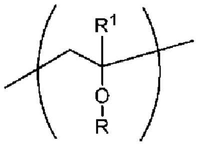
(5)

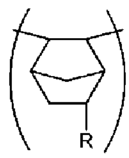
(6)

In the formulas (1) to (6), a substituent group R is a substituent group containing partial structures each independently containing an aromatic ring, and $R^1$ is a hydrogen atom or a methyl group. In this specification, in constituent units represented by the chemical formulas (1) to (6), a portion other than R is the main chain of a specific polymer. The formula weight of the substituent group R is 80 or more, preferably 100 or more, more preferably 130 or more, and further preferably 150 or more. The upper limit of the formula weight of the substituent group R is practically 500 or less.

A polymer having a polymerizable functional group is normally a compound having a weight-average molecular weight of 500 or more. The weight-average molecular weight is preferably 1,000 or more, and more preferably 2,000 or more. The upper limit of the weight-average molecular weight is not particularly determined, but is preferably, for example, 50,000 or less. When the weight-average molecular weight is set at the above-described lower limit or more, it is possible to set the boiling point at 250°C or more, and further improve the mechanical properties after curing. Also, when the weight-average molecular weight is set at the above-described upper limit or less, the solubility to the solvent increases, and the flowability of discretely arranged droplets is maintained because the viscosity is not too high. This makes it possible to further improve the flatness of the liquid film surface. Note that the weight-average molecular weight (Mw) in this embodiment is a molecular weight measured by gel permeation chromatography (GPC) unless it is specifically stated otherwise.

Practical examples of the polymerizable functional group of the polymer are a (meth)acryloyl group, an epoxy group, an oxetane group, a methylol group, a methylol ether group, and a vinyl ether group. A (meth)acryloyl group is particularly favorable from the viewpoint of polymerization easiness.

When adding the polymer having the polymerizable functional group as at least a part of the component (a), the blending ratio can freely be set as long as the blending ratio falls within the range of the viscosity regulation to be described later. For example, the blending ratio of polymer to the total mass of all the components except for the solvent (d) is preferably 0.1 wt% or more and 60 wt% or less, more preferably 1 wt% or more and 50 wt% or less, and further preferably 10 wt% or more and 40 wt% or less. When the blending ratio of the polymer having the polymerizable functional group is set at 0.1 wt% or more, it is possible to improve the dry etching resistance, the heat resistance, the mechanical strength, and the low volatility. Also, when the blending ratio is set at 60 wt% or less, it is possible to make the blending ratio fall within the range of the upper limit regulation of the viscosity (to be described later).

<Component (b): Photopolymerization Initiator>

The component (b) is a photopolymerization initiator. In this specification, the photopolymerization initiator is a compound that senses light having a predetermined wavelength and generates a polymerization factor (radical) described earlier. More specifically, the photopolymerization initiator is a polymerization initiator (radical generator) that generates a

radical by light (infrared light, visible light, ultraviolet light, far-ultraviolet light, X-ray, a charged particle beam such as an electron beam, or radiation). The component (b) can be formed by only one type of a photopolymerization initiator, and can also be formed by a plurality of types of photopolymerization initiators.

Examples of the radical generator are as follows, but the radical generator is not limited to these examples.

2,4,5-triarylimidazole dimers that can have substituent groups, such as a 2-(o-chlorophenyl)-4,5-diphenylimidazole dimer, a 2-(o-chlorophenyl)-4,5-di(methoxyphenyl)imidazole dimer, a 2-(o-fluorophenyl)-4,5-diphenylimidazole dimer, and a 2-(o- or p-methoxyphenyl)-4,5-diphenylimidazole dimer; benzophenone derivatives such as benzophenone, N,N'-tetramethyl-4,4'-diaminobenzophenone (Michiler's ketone), N,N'-tetraethyl-4,4'-diaminobenzophenone, 4-methoxy-4'-dimethylaminobenzophenone, 4-chlorobenzophenone, 4,4'-dimethoxybenzophenone, and 4,4'-diaminobenzophenone; $\alpha$-amino aromatic ketone derivatives such as 2-benzyl-2-dimethylamino-1-(4-morpholinophenyl)-butanone-1,2-methyl-1-[4-(methylthio)phenyl]-2-morpholino-propane-1-one; quinones such as 2-ethyl anthraquinone, phenanthrenequinone, 2-t-butylanthraquinone, octamethylanthraquinone, 1,2-benzanthraquinone, 2,3-benzanthraquinone, 2-phenylanthraquinone, 2,3-diphenylanthraquinone, 1-chloroanthraquinone, 2-methylanthraquinone, 1,4-naphtoquinone, 9,10-phenanthraquinone, 2-methyl-1,4-naphtoquinone, and 2,3-dimethylanthraquinone; benzoin ether derivatives such as benzoin methyl ether, benzoin ethyl ether, and benzoin phenyl ether; benzoin derivatives such as benzoin, methyl benzoin, ethyl benzoin, and propyl benzoin; benzyl derivatives such as benzyldimethylketal; acridine derivatives such as 9-phenylacridine and 1,7-bis(9,9'-acrydinyl)heptane; N-phenylglycine derivatives such as N-phenylglycine; acetophenone derivatives such as acetophenone, 3-methylacetophenone, acetophenone benzylketal, 1-hydroxycyclohexyl phenylketone, and 2,2-dimethoxy-2-phenyl acetophenone; thioxanthone derivatives such as thioxanthone, diethylthioxanthone, 2-isopropylthioxanthone, and 2-chlorothioxanthone; acylphosphine oxide derivatives such as 2,4,6-trimethylbenzoyldiphenylphosphine oxide, bis(2,4,6-trimethylbenzoyl)phenylphosphine oxide, and bis-(2,6-dimethoxybenzoyl)-2,4,4-trimethylpentylphosphine oxide; oxime ester derivatives such as 1,2-octanedione, 1-[4-(phenylthiol)-,2-(O-benzoyloxime)], ethanone, 1-[9-ethyl-6-(2-methylbenzoyl)-9H-carbazole-3-yl]-, and 1-(O-acetyloxime); and xanthone, fluorenone, benzaldehyde, fluorene, anthraquinone, triphenylamine, carbazole, 1-(4-isopropylphenyl)-2-hydroxy-2-methylpropane-1-one, and 2-hydroxy-2-methyl-1-phenylpropane-1-one.

Examples of commercially available products of the above-described radical generators are as follows, but the products are not limited to these examples.

Irgacure 184, 369, 651, 500, 819, 907, 784, and 2959, CGI-1700, -1750, and -1850, CG24-61, Darocur 1116 and 1173, Lucirin® TPO, LR8893, and LR8970 (manufactured by BASF), and Ubecryl P36 (manufactured by UCB).

Of the above-described radical generators, the component (b) is preferably an acylphosphine oxide-based polymerization initiator. Note that of the above-described radical generators, the acylphosphine oxide-based polymerization initiators are as follows.

Acylphosphine oxide compounds such as 2,4,6-trimethylbenzoyl diphenylphosphine oxide, bis(2,4,6-trimethylbenzoyl)phenylphosphine oxide, and bis(2,6-dimethoxybenzoyl)-2,4,4-trimethylpentylphosphine oxide.

The blending ratio of the component (b) in the curable composition (A) is preferably 0.1 wt% or more and 50 wt% or less with respect to the sum of the component (a), the component (b), and a component (c) (to be described later), that is, the total mass of all the components except for the solvent (d). Also, the blending ratio of the component (b) in the curable composition (A) is more preferably 0.1 wt% or more and 20 wt% or less, and further preferably 1 wt% or more and 20 wt% or less with respect to the total mass of all the components except for the solvent (d). When the blending ratio of the component (b) is set at 0.1 wt% or more, the curing rate of the composition increases, so the reaction efficiency can be improved. Also, when the blending ratio of the component (b) is set at 50 wt% or less, a cured film having mechanical strength to some extent can be obtained.

<Component (c): Nonpolymerizable Compound>

**In** addition to the components (a) and (b) described above, the curable composition (A) according to the embodiment of the present invention can further contain a nonpolymerizable compound as the component (c) in accordance with various purposes within a range that does not impair the effect of the present invention. An example of the component (c) is a compound that does not contain a polymerizable functional group such as a (meth)acryloyl group, and does not have the ability to sense light having a predetermined wavelength and generate the polymerization factor (radical) described previously. Examples of the nonpolymerizable compound are a sensitizer, a hydrogen donor, an internal mold release agent, an antioxidant, a polymer component, and other additives. The component (c) can contain a plurality of types of the above-described compounds.

The sensitizer is a compound that is properly added for the purpose of promoting the polymerization reaction and improving the reaction conversion rate. As the sensitizer, it is possible to use one type of a compound alone, or to use two or more types of compounds by mixing them.

An example of the sensitizer is a sensitizing dye. The sensitizing dye is a compound that is excited by absorbing light having a specific wavelength and has an interaction with a photopolymerization initiator as the component (b). The

"interaction" herein mentioned is energy transfer or electron transfer from the sensitizing dye in the excited state to the photopolymerization initiator as the component (b). Practical examples of the sensitizing dye are as follows, but the sensitizing dye is not limited to these examples.

An anthracene derivative, an anthraquinone derivative, a pyrene derivative, a perylene derivative, a carbazole derivative, a benzophenone derivative, a thioxanthone derivative, a xanthone derivative, a coumarin derivative, a phenothiazine derivative, a camphorquinone derivative, an acridinic dye, a thiopyrylium salt-based dye, a merocyanine-based dye, a quinoline-based dye, a styryl quinoline-based dye, a ketocoumarin-based dye, a thioxanthenebased dye, a xanthene-based dye, an oxonol-based dye, a cyanine-based dye, a rhodamine-based dye, and a pyrylium salt-based dye.

The hydrogen donor is a compound that reacts with an initiation radical generated from the photopolymerization initiator as the component (b) or a radical at a polymerization growth end, and generates a radical having higher reactivity. The hydrogen donor is preferably added when the photopolymerization initiator as the component (b) is a photo-radical generator.

Practical examples of the hydrogen donor as described above are as follows, but the hydrogen donor is not limited to these examples.

Amine compounds such as n-butylamine, di-n-butylamine, tri-n-butylphosphine, allylthiourea, s-benzylisothiuronium-p-toluenesulfinate, triethylamine, diethylaminoethyl methacrylate, triethylenetetramine, 4,4'-bis(dialkylamino) benzophenone, N,N-dimethylamino ethylester benzoate, N,N-dimethylamino isoamylester benzoate, pentyl-4-dimethylamino benzoate, triethanolamine, and N-phenylglycine; and mercapto compounds such as 2-mercapto-N-phenylbenzoimidazole and mercapto propionate ester.

It is possible to use one type of a hydrogen donor alone, or to use two or more types of hydrogen donors by mixing them. The hydrogen donor can also have a function as a sensitizer.

An internal mold release agent can be added to the curable composition for the purpose of reducing the interface bonding force between a mold and the curable composition, that is, reducing the mold release force in a mold release step (to be described later). In this specification, "internal" means that the mold release agent is added to the curable composition in advance before a curable composition arranging step. As the internal mold release agent, it is possible to use surfactants such as a silicon-based surfactant, a fluorine-based surfactant, and a hydrocarbon-based surfactant. However, the addition amount of the fluorine-based surfactant according to the embodiment of present invention is limited as will be described later. Note that the internal mold release agent according to the embodiment of the present invention is not polymerizable. It is possible to use one type of an internal mold release agent alone, or to use two or more types of internal mold release agents by mixing them.

The fluorine-based surfactant includes the following.

A polyalkylene oxide (for example, polyethylene oxide or polypropylene oxide) adduct of alcohol having a perfluoroalkyl group, and a polyalkylene oxide (for example, polyethylene oxide or polypropylene oxide) adduct of perfluoropolyether.

Note that the fluorine-based surfactant can have a hydroxyl group, an alkoxy group, an alkyl group, an amino group, or a thiol group in a portion (for example, a terminal group) of the molecular structure. An example is pentadecaethyleneglycol mono1H,1H,2H,2H-perfluorooctylether.

It is also possible to use a commercially available product as the fluorine-based surfactant. Examples of the commercially available product of the fluorine-based surfactant are as follows.

MEGAFACE® F-444, TF-2066, TF-2067, and TF-2068, and DEO-15 (abbreviation) (manufactured by DIC); Fluorad FC-430 and FC-431 (manufactured by Sumitomo 3M); Surflon® S-382 (manufactured by AGC); EFTOP EF-122A, 122B, 122C, EF-121, EF-126, EF-127, and MF-100 (manufactured by Tochem Products); PF-636, PF-6320, PF-656, and PF-6520 (manufactured by OMNOVA Solutions); UNIDYNE® DS-401, DS-403, and DS-451 (manufactured by DAIKIN); and FUTAGENT® 250, 251, 222F, and 208G (manufactured by NEOS).

The internal mold release agent can also be a hydrocarbon-based surfactant. The hydrocarbon-based surfactant includes an alkyl alcohol polyalkylene oxide adduct obtained by adding alkylene oxide having a carbon number of 2 to 4 to alkyl alcohol having a carbon number of 1 to 50, and polyalkylene oxide.

Examples of the alkyl alcohol polyalkylene oxide adduct are as follows.

A methyl alcohol ethylene oxide adduct, a decyl alcohol ethylene oxide adduct, a lauryl alcohol ethylene oxide adduct, a cetyl alcohol ethylene oxide adduct, a stearyl alcohol ethylene oxide adduct, and a stearyl alcohol ethylene oxide/propylene oxide adduct.

Note that the terminal group of the alkyl alcohol polyalkylene oxide adduct is not limited to a hydroxyl group that can be manufactured by simply adding polyalkylene oxide to alkyl alcohol. This hydroxyl group can also be substituted by a polar functional group such as a carboxyl group, an amino group, a pyridyl group, a thiol group, or a silanol group, or by a hydrophobic group such as an alkyl group or an alkoxy group.

Examples of polyalkylene oxide are as follows.

Polyethylene glycol, polypropylene glycol, their mono or dimethyl ether, mono or dioctyl ether, mono or dinonyl

ether, and mono or didecyl ether, monoadipate, monooleate, monostearate, and monosuccinate.

A commercially available product can also be used as the alkyl alcohol polyalkylene oxide adduct. Examples of the commercially available product of the alkyl alcohol polyalkylene oxide adduct are as follows.

Polyoxyethylene methyl ether (a methyl alcohol ethylene oxide adduct) (BLAUNON MP-400, MP-550, and MP-1000) manufactured by AOKI OIL INDUSTRIAL, polyoxyethylene decyl ether (a decyl alcohol ethylene oxide adduct) (FINESURF D-1303, D-1305, D-1307, and D-1310) manufactured by AOKI OIL INDUSTRIAL, polyoxyethylene lauryl ether (a lauryl alcohol ethylene oxide adduct) (BLAUNON EL-1505) manufactured by AOKI OIL INDUSTRIAL, polyoxyethylene cetyl ether (a cetyl alcohol ethylene oxide adduct) (BLAUNON CH-305 and CH-310) manufactured by AOKI OIL INDUSTRIAL, polyoxyethylene stearyl ether (a stearyl alcohol ethylene oxide adduct) (BLAUNON SR-705, SR-707, SR-715, SR-720, SR-730, and SR-750) manufactured by AOKI OIL INDUSTRIAL, randomly polymerized polyoxyethylene polyoxypropylene stearyl ether (BLAUNON SA-50/50 1000R and SA-30/70 2000R) manufactured by AOKI OIL INDUSTRIAL, polyoxyethylene methyl ether (Pluriol® A760E) manufactured by BASF, and polyoxyethylene alkyl ether (EMULGEN series) manufactured by KAO.

A commercially available product can also be used as polyalkylene oxide. An example is an ethylene oxide/propylene oxide copolymer (Pluronic PE6400) manufactured by BASF.

The fluorine-based surfactant shows an excellent mold release force reducing effect and hence is effective as an internal mold release agent. The blending ratio of the component (c) in the curable composition (A) except for the fluorine-based surfactant is preferably 0 wt% or more and 50 wt% or less with respect to the sum of the components (a), (b), and (c), that is, the total mass of all the components except for the solvent (d). The blending ratio of the component (c) in the curable composition (A) except for the fluorine-based surfactant is more preferably 0.1 wt% or more and 50 wt% or less, and further preferably 0.1 wt% or more and 20 wt% or less with respect to the total mass of all the components except for the solvent (d). When the blending ratio of the component (c) except for the fluorine-based surfactant is set at 50 wt% or less, a cured film having mechanical strength to some extent can be obtained.

<Component (d): Solvent>

The curable composition according to the embodiment of the present invention contains a solvent having a boiling point of 100°C or more and less than 250°C at normal pressure as the component (d). The component (d) is a solvent that dissolves the components (a), (b), and (c). Examples are an alcohol-based solvent, a ketone-based solvent, an ether-based solvent, and a nitrogen-containing solvent. As the component (d), it is possible to use one type of a component alone, or to use two or more types of components by combining them. The boiling point at normal pressure of the component (d) is 100°C or more, preferably 140°C or more, and particularly preferably 150°C or more. The boiling point at normal pressure of the component (d) is less than 250°C, and preferably less than 200°C. If the boiling point of the component (d) at normal pressure is less than 100°C, the volatilization speed in the waiting step to be described later is too high. For this reason, the component (d) may volatilize before the droplets of the curable composition (A) bond to each other, and the droplets of the curable composition (A) may not bond to each other. Also, if the boiling point at normal pressure of the component (d) is 250°C or more, it is possible that the volatilization of the component (d) is insufficient in the waiting step to be described later, so the component (d) remains in the cured product of the curable composition (A). Here, if the component (d) includes one or more types of solvents, the boiling point of each of the one or more types of solvents at normal pressure is preferably 100°C or more and less than 250°C (for example, 100°C or more and less than 200°C).

Examples of the alcohol-based solvent are as follows.

Monoalcohol-based solvents such as methanol, ethanol, n-propanol, isopropanol, n-butanol, iso-butanol, sec-butanol, tert-butanol, n-pentanol, isopentanol, 2-methylbutanol, sec-pentanol, tert-pentanol, 3-methoxybutanol, n-hexanol, 2-methylpentanol, sec-hexanol, 2-ethylbutanol, sec-heptanol, 3-heptanol, n-octanol, 2-ethylhexanol, sec-octanol, n-nonyl alcohol, 2,6-dimethylheptanol-4, n-decanol, sec-undecyl alcohol, trimethylnonyl alcohol, sec-tetradecyl alcohol, sec-heptadecyl alcohol, phenol, cyclohexanol, methylcyclohexanol, 3,3,5-trimethylcyclohexanol, benzyl alcohol, phenylmethylcarbinol, diacetone alcohol, and cresol; and polyalcohol-based solvents such as ethylene glycol, 1,2-propylene glycol, 1,3-butylene glycol, 2,4-pentanediol, 2-methyl-2,4-pentanediol, 2,5-hexanediol, 2,4-heptanediol, 2-ethyl-1,3-hexanediol, diethylene glycol, dipropylene glycol, triethylene glycol, tripropylene glycol, and glycerin.

Examples of the ketone-based solvent are as follows.

Acetone, methylethylketone, methyl-n-propylketone, methyl-n-butyl ketone, diethylketone, methyl-iso-butylketone, methyl-n-pentylketone, ethyl-n-butylketone, methyl-n-hexylketone, di-iso-butylketone, trimethylnonanon, cyclohexanone, methylcyclohexanone, 2,4-pentanedione, acetonylacetone, diacetone alcohol, acetophenone, and fenthion.

Examples of the ether-based solvent are as follows.

Ethyl ether, iso-propyl ether, n-butyl ether, n-hexyl ether, 2-ethylhexyl ether, ethylene oxide, 1,2-propylene oxide, dioxolane, 4-methyldioxolane, dioxane, dimethyldioxane, 2-methoxyethanol, 2-ethoxyethanol, ethylene glycol diethyl ether, 2-n-butoxyethanol, 2-n-hexoxyethanol, 2-phenoxyethanol, 2-(2-ethylbutoxy)ethanol, ethylene glycol dibutyl ether, diethylene glycol monomethyl ether, diethylene glycol monoethyl ether, diethylene glycol diethyl ether, diethylene glycol

mono-n-butyl ether, diethylene glycol di-n-butyl ether, diethylene glycol mono-n-hexyl ether, ethoxy triglycol, tetraethylene glycol di-n-butyl ether, 1-n-butoxy-2-propanol, 1-phenoxy-2-propanol, propylene glycol monomethyl ether, propylene glycol monoethyl ether, propylene glycol monopropyl ether, dipropylene glycol monomethyl ether, dipropylene glycol monoethyl ether, dipropylene glycol monopropyl ether, tripropylene glycol monomethyl ether, tetrahydrofuran, and 2-methyltetrahydrofuran.

Examples of the ester-based solvent are as follows.

Diethyl carbonate, methyl acetate, ethyl acetate, amyl acetate, γ-butyrolactone, γ-valerolactone, n-propyl acetate, iso-propyl acetate, n-butyl acetate, iso-butyl acetate, sec-butyl acetate, n-pentyl acetate, sec-pentyl acetate, 3-methoxybutyl acetate, methylpentyl acetate, 2-ethylbutyl acetate, 2-ethylhexyl acetate, benzyl acetate, cyclohexyl acetate, methylcyclohexyl acetate, n-nonyl acetate, methyl acetoacetate, ethyl acetoacetate, ethylene glycol monomethyl ether acetate, ethylene glycol monoethyl ether acetate, diethylene glycol monomethyl ether acetate, diethylene glycol monoethyl ether acetate, diethylene glycol mono-n-butyl ether acetate, propylene glycol monomethyl ether acetate, propylene glycol monoethyl ether acetate, propylene glycol monopropyl ether acetate, propylene glycol monobutyl ether acetate, dipropylene glycol monomethyl ether acetate, dipropylene glycol monoethyl ether acetate, glycol diacetate, methoxy triglycol acetate, ethyl propionate, n-butyl propionate, iso-amyl propionate, diethyl oxalate, di-n-butyl oxalate, methyl lactate, ethyl lactate, n-butyl lactate, n-amyl lactate, diethyl malonate, dimethyl phthalate, and diethyl phthalate.

Examples of the nitrogen-containing solvent are as follows.

N-methylformamide, N,N-dimethylformamide, N,N-diethylformamide, acetoamide, N-methylacetoamide, N,N-dimethylacetoamide, N-methylpropionamide, and N-methylpyrrolidone.

Of the above-described solvents, the ether-based solvent and the ester-based solvent are favorable. Note that an ether-based solvent and an ester-based solvent each having a glycol structure are more favorable from the viewpoint of good film formation properties.

Further favorable examples of the solvent are as follows.

Propylene glycol monomethyl ether, propylene glycol monoethyl ether, propylene glycol monopropyl ether, propylene glycol monomethyl ether acetate, propylene glycol monoethyl ether acetate, and propylene glycol monopropyl ether acetate.

A particularly favorable example is propylene glycol monomethyl ether acetate. Note that (ethyl) isocyanurate di(meth)acrylate is also favorable.

In the embodiment, a favorable solvent is a solvent having at least one of an ester structure, a ketone structure, a hydroxyl group, and an ether structure. More specifically, a favorable solvent is one solvent or a solvent mixture selected from propylene glycol monomethyl ether acetate (boiling point = 146°C), propylene glycol monomethyl ether, cyclohexanone, 2-haptanone, γ-butyrolactone, and ethyl lactate.

In the embodiment, if the surface tension of the curable composition in a state in which the solvent (d) is removed is $\gamma 1$ (mN/m), the surface tension of the solvent (d) at 23°C is y2 (mN/m), and $\Delta\gamma = \gamma 1 - \gamma 2$,, the curable composition is configured such that $\Delta\gamma$ is larger than zero. More specifically, the solvent (d) is selected such that $\Delta\gamma$ is larger than zero. If $\Delta\gamma$ is larger than zero, in the waiting step to be described later, spread of each droplet of the curable composition is accelerated by the Marangoni effect, and the droplets quickly bond to each other to form a continuous liquid film. In addition, since volatilization of the solvent is accelerated by the quick spread of the droplets, the waiting step to be described later is completed in a short time, or the conditions of a baking step are relaxed or omitted. $\Delta\gamma$ is preferably 0.1 or more, particularly preferably 1.0 or more, and further preferably 2.0 or more. Note that $\gamma 1$ and $\gamma 2$ are each a surface tension at normal pressure.

Also, in the embodiment, a polymerizable compound having a boiling point of 80°C or more and less than 250°C at normal pressure is also usable as the component (d). Examples of the polymerizable compound having a boiling point of 80°C or more and less than 250°C at normal pressure are as follows.

Cyclohexyl acrylate (boiling point = 198°C), benzyl acrylate (boiling point = 229°C), isobornyl acrylate (boiling point = 245°C), tetrahydrofurfuryl acrylate (boiling point = 202°C), trimethylcyclohexyl acrylate (boiling point = 232°C), isooctyl acrylate (217°C), n-octyl acrylate (boiling point = 228°C), ethoxyethoxyethyl acrylate (boiling point = 230°C), divinylbenzene (boiling point = 193°C), 1,3-diisopropenylbenzene (boiling point = 218°C), styrene (boiling point = 145°C), and α-methylstyrene (boiling point = 165°C).

**In** the embodiment, when the whole of the curable composition (A) is 100 vol%, the content of the solvent (d) is 5 vol% or more and 95 vol% or less, preferably 15 vol% or more and 85 vol% or less, and further preferably 50 vol% or more and 80 vol% or less. In an example, the content of the solvent (d) can be 50 vol% or more and 85 vol% or less. If the content of the solvent (d) is smaller than 5 vol%, it is impossible to obtain a thin film after the solvent (d) volatilized under the condition that a practically continuous liquid film can be obtained. Also, if the content of the solvent (d) is larger than 95 vol%, it is impossible to obtain a thick film after the solvent (d) volatilized even when droplets are closely dropped by an inkjet method.

<Temperature When Blending Curable Composition>

When preparing the curable composition (A) according to the embodiment, at least the components (a), (b), and (d) are mixed and dissolved under a predetermined temperature condition. More specifically, the predetermined temperature condition falls within the range of 0°C or more and 100°C or less. Note that the same applies to a case in which the curable composition (A) contains the component (c).

<Viscosity of Curable Component>

The curable composition (A) according to the embodiment is a liquid. This is so because droplets of the curable composition (A) are discretely dropped on a substrate by an inkjet method. The viscosity of the curable composition (A) according to the embodiment is 1.3 mPa·s or more and 60 mPa·s or less at 23°C, preferably 2 mPa·s or more and 30 mPa·s or less, and more preferably 5 mPa·s or more and 15 mPa·s or less. If the viscosity of the curable composition (A) is smaller than 2 mPa·s, the discharge property of droplets by an inkjet method is unstable. Also, if the viscosity of the curable composition (A) is larger than 60 mPa·s, it is impossible to form droplets in a volume of about 1.0 to 3.0 pL, which is favorable in the embodiment.

The viscosity in a state in which the solvent (d) volatilized from the curable composition (A), that is, the viscosity of a mixture of components except for the solvent (d) of the curable composition (A) at 23°C is 30 mPa·s or more and 10,000 mPa·s or less. The viscosity of the mixture of components except for the solvent (d) of the curable composition (A) at 23°C is preferably 90 mPa·s or more and 2,000 mPa·s or less, for example, 120 mPa·s or more and 1,000 mPa·s or less. Also, the viscosity is further preferably 150 mPa·s or more and 500 mPa·s or less. When the viscosity of the components except for the solvent (d) of the curable composition (A) is set to 1,000 mPa·s or less, spreading and filling are rapidly completed when bringing the curable composition (A) into contact with a mold. Accordingly, the use of the curable composition (A) according to the embodiment of the present invention makes it possible to perform an imprinting process at high throughput, and suppress pattern defects caused by insufficient filling. Also, when the viscosity of components except for the solvent (d) of the curable composition (A) is set to 1 mPa·s or more, it is possible to prevent an unnecessary flow of droplets of the curable composition (A) after the solvent (d) volatilized. Furthermore, when bringing the curable composition (A) into contact with a mold, the curable composition (A) does not easily flow out from the end portions of the mold.

<Surface Tension of Curable Composition>

As for a surface tension $\gamma 1$ in a state in which the solvent (d) volatilizes from the curable composition (A) according to the embodiment of the present invention, the surface tension at 23°C is preferably 5 mN/m or more and 70 mN/m or less. Also, the surface tension at 23°C of the composition of the components except for the solvent (component (d)) is more preferably 7 mN/m or more and 50 mN/m or less, and further preferably 10 mN/m or more and 40 mN/m or less. Note that when the surface tension is high, for example, 5 mN/m or more, the capillarity strongly acts, so filling (spreading and filling) is complete within a short time period when the curable composition (A) and a mold are brought into contact with each other. Also, when the surface tension is 70 mN/m or less, a cured film obtained by curing the curable composition has surface smoothness.

<Contact Angle of Curable Composition>

As for the contact angle of the curable composition (A) according to the embodiment of the present invention, for the composition of the components except the solvent (component (d), the contact angle is preferably 0° or more and 90° or less and particularly preferably 0° or more and 10° or less with respect to both the surface of a substrate and the surface of a mold. If the contact angle is larger than 90°, the capillarity acts in a negative direction (a direction in which the contact interface between the mold and the curable composition is shrunk) inside a pattern of the mold or in a gap between the substrate and the mold, and this may make filling impossible. When the contact angle is small, the capillarity strongly acts, and the filling rate increases.

<Impurities Mixed in Curable Composition>

The curable composition (A) according to the embodiment of the present invention preferably contains impurities as little as possible. Note that impurities mean components other than the components (a), (b), (c), and (d) described above. Therefore, the curable composition (A) according to the embodiment of the present invention is favorably a composition obtained through a refining step. A refining step like this is preferably filtration using a filter.

As this filtration using a filter, it is favorable to mix the components (a), (b), and (c) described above, and filtrate the

mixture by using, for example, a filter having a pore diameter of 0.001 μm or more and 5.0 μm or less. When performing filtration using a filter, it is further favorable to perform the filtration in multiple stages, or to repetitively perform the filtration a plurality of times (cycle filtration). It is also possible to re-filtrate a liquid once filtrated through a filter, or perform filtration by using filters having different pore diameters. Examples of the filter for use in filtration are filters made of, for example, a polyethylene resin, a polypropylene resin, a fluorine resin, and a nylon resin, but the filter is not particularly limited. Impurities such as particles mixed in the curable composition can be removed through the refining step as described above. Consequently, it is possible to prevent impurities mixed in the curable composition from causing pattern defects by forming unexpected unevenness on a cured film obtained after the curable composition is cured.

<Glass Transition Temperature of Curable Composition after Curing>

If a glass transition temperature is much higher than the temperature at the time of mold release, the cured product at the time of mold release exhibits a firm glass state, that is, a high mechanical strength. For this reason, pattern collapse or breakage due to impact of mold release hardly occurs. Hence, when executing the mold release step at room temperature, the glass transition temperature of the cured product is preferably 70°C or more, more preferably 100°C or more, and particularly preferably 150°C or more.

As a method of measuring the glass transition temperature of the cured product (photocured product), measurement using differential scanning calorimetry (DSC) or a dynamic viscoelasticity measuring apparatus can be applied. For example, when measurement is performed using DSC, a line obtained by extending the baseline of the DSC curve of a photocured product on the low temperature side (a DSC curve portion in a temperature region where neither transition nor reaction occurs in a test piece) to the high temperature side and a tangent drawn at a point where the gradient of the curve of the stepwise change portion of glass transition is maximum are obtained. From the intersection between the line and the tangent, an extrapolated glass transition start temperature (Tig) is obtained, and this can be obtained as the glass transition temperature. An example of a major apparatus is STA-6000 (manufactured by PerkinElmer). On the other hand, when performing measurement using a dynamic viscoelasticity measuring apparatus, a temperature at which the loss tangent (tanδ) of the photocured product is maximum is defined as the glass transition temperature. An example of a major apparatus capable of measuring dynamic viscoelasticity is MCR301 (manufactured by Anton Paar).

When using the curable composition according to the embodiment of the present invention in order to fabricate a semiconductor integrated circuit, it is favorable to avoid mixing of impurities (metal impurities) containing metal atoms in the curable composition as much as possible so as not to obstruct the operation of a product. The concentration of the metal impurities contained in the curable composition is preferably 10 ppm or less, and more preferably 100 ppb or less.

[Substrate]

In this specification, a member on which droplets of the curable composition (A) are discretely dropped is explained as a substrate.

This substrate is a substrate to be processed, and a silicon wafer is normally used. The substrate can have a layer to be processed on the surface. On the substrate, another layer can also be formed below the layer to be processed. When a quartz substrate is used as the substrate, a replica (replica mold) of a mold for imprinting can be manufactured. However, the substrate is not limited to a silicon wafer or a quartz substrate. The substrate can freely be selected from those known as semiconductor device substrates such as aluminum, a titanium-tungsten alloy, an aluminum-silicon alloy, an aluminum-copper-silicon alloy, silicon oxide, and silicon nitride. Note that the surface of the substrate or of the layer to be processed is preferably treated by a surface treatment such as a silane coupling treatment, a silazane treatment, or deposition of an organic thin film, thereby improving the adhesion to the curable composition (A). As a practical example of the organic thin film to be deposited as the surface treatment, an adhesive layer described in PTL 4 can be used.

[Film Forming Method]

The film forming method according to the embodiment will be explained with reference to Figs. 1[1] to 1[7]. The film forming method according to this embodiment forms a film of a curable composition in a space between a mold and a substrate using the photoimprint method. However, the curable composition can also be cured by another energy (for example, heat or an electromagnetic wave). The film forming method according to this embodiment can be performed as a method of forming a film having a pattern, that is, as a pattern forming method, and can also be performed as a method of forming a film (for example, a planarization film) having no pattern, that is, as a planarization film forming method.

The cured film formed by the pattern forming method according to this embodiment is preferably a film having a pattern with a size of 1 nm or more and 10 mm or less, and more preferably a film having a pattern with a size of 10 nm or more and 100 μm or less. Generally, a film forming method of forming a film having a pattern (uneven structure) of a nano size (1 nm or more and 100 nm or less) by using light is called a photoimprint method.

An example in which a pattern forming method is applied as a film forming method according to this embodiment will be explained below. The pattern forming method includes, for example, a forming step, an arranging step, a waiting step, a contact step, a curing step, and a mold release step. The forming step is a step of forming an underlayer. The arranging step is a step of discretely arranging droplets of the curable composition (A) on the underlayer. The waiting step is a step of waiting until the droplets of the curable composition (A) bond to each other and the solvent (d) volatilizes. The contact step is a step of bringing the curable composition (A) and a mold in contact with each other. The curing step is a step of curing the curable composition (A). The mold release step is a step of releasing the mold from the cured film of the curable composition (A). The arranging step is performed after the forming step, the waiting step is performed after the arranging step, the contact step is performed after the waiting step, the curing step is performed after the contact step, and the mold release step is performed after the curing step.

<Arranging Step>

In the arranging step, as schematically shown in Fig. 1[1], droplets of the curable composition (A) are discretely arranged on a substrate. In the arranging step, the droplets of the curable composition (A) having a volume of 1.0 pL or more can be arranged at a density of 80 droplets/$mm^2$ or more. A substrate on which an underlayer is stacked may be used as the substrate. In addition, the adhesion of the surface of the substrate with respect to the curable composition (A) can be improved by a surface treatment such as a silane coupling treatment, a silazane treatment, or deposition of an organic thin film.

An inkjet method is particularly favorable as the arranging method of arranging the droplets of the curable composition (A) on the substrate. It is favorable to arrange the droplets of the curable composition (A) densely on that region of the substrate, which faces a region in which concave portions forming the pattern of a mold densely exist, and sparsely on that region of the substrate, which faces a region in which convex portions forming the pattern of the mold sparsely exist. Consequently, a film (residual film) (to be described later) of the curable composition (A) formed on the substrate is controlled to have a uniform thickness regardless of the sparsity and density of the pattern of the mold.

An index called an average residual liquid film thickness is defined in order to prescribe the volume of the curable composition (A) to be arranged. The average residual liquid film thickness is a value obtained by dividing the total volume of the curable composition (A) (except the solvent (d)) to be arranged in the arranging step by the area of a film formation region of the mold. The volume of the curable composition (A) (except the solvent (d)) is the sum total of the volumes of the individual droplets of the curable composition (A) after the solvent (d) volatilized. According to this definition, the average residual liquid film thickness can be prescribed regardless of the state of unevenness even when the substrate surface is uneven. Here, the average residual liquid film thickness may be understood as a value obtained by dividing another track of the curable composition (A) remaining after the waiting step to be described later by the area of the film formation region of the mold, and is preferably 20 nm or less.

<Waiting Step>

In the embodiment of the present invention, the waiting step is provided during time after the arranging step and before the contact step. Here, a value obtained by dividing the total volume of the droplets of the curable composition (A) dropped in one-time pattern formation by the total area of regions (pattern formation regions) in which patterns are formed in one-time pattern formation is defined as an average initial liquid film thickness. In the waiting step, as schematically shown in Fig. 1[2], the droplets of the curable composition (A) spread on the substrate. Consequently, the whole pattern formation region of the substrate is covered with the curable composition (A). In the embodiment, if the surface tension of the curable composition in a state in which the solvent (d) is removed is $\gamma 1$ (mN/m), and the surface tension of the solvent (d) is y2 (mN/m), the curable composition is formed such that $\gamma 1$ is larger than y2. More specifically, the solvent (d) is selected such that $\gamma 1$ is larger than y2. When the solvent (d) is thus selected, the dropped droplets largely spread (that is, the spreading speed of the dropped droplets increases). A factor for this will be described below.

In the embodiment, since the dropped droplets contain a volatile component, the concentration of the volatile component changes due to volatilization after dropping. The surface tension $\gamma 1$ of nonvolatile components is larger than the surface tension y2 of the volatile component. For this reason, if the concentration of the volatile component lowers along with the volatilization, the surface tension becomes large.

Also, in general, after the dropped droplets gradually spread, the spread of the droplets stops at a static contact angle. The spreading speed is high when the contact angle to the substrate at the end portion of the droplet is greatly different from the static contact angle.

Also, in the embodiment, the thickness of the cured film is very thin as compared to the radius of the droplet, and concentration diffusion in the radial direction is very slow as compared to concentration diffusion in the thickness direction.

The behavior of a droplet after dropping will be described below with reference to Fig. 2. Fig. 2 shows a state in which a droplet dropped on the substrate spreads, and reference numeral 301 denotes a substrate; and 302, a droplet

dropped on the substrate. As described above, volatilization of the solvent component progresses even halfway through the spread of the droplet. The volatilization speed largely depends on the surface area of the droplet. Hence, when comparing the center portion of the droplet (a region 303 indicated by a dotted line rectangle) and the end portion of the droplet (a region 304 indicated by a dotted line rectangle), the surface area is slightly larger and the volatilization speed is higher at the end portion of the droplet. On the other hand, the volume of the droplet is smaller at the end portion of the droplet (region 304) than at the center portion of the droplet (region 303). For this reason, at the end portion of the droplet (region 304), since the volatilization speed is high and the volume is small as compared to the center portion of the droplet (region 303), the concentration of the volatile component lowers, and the surface tension increases. Since the surface tension is higher at the end portion of the droplet (region 304) than at the center portion of the droplet (region 303), a force is generated from the center portion of the droplet to the end portion of the droplet by the Marangoni effect, and a flow of the droplet is induced.

The droplet in a case where the flow of the droplet is induced by the Marangoni effect has a shape as shown in Fig. 3. In Fig. 3, reference numeral 301 denotes the substrate; and 302, the droplet dropped on the substrate. As a result of inducing the flow of the droplet toward the end portion of the droplet, as shown in Fig. 3, the droplet 302 has a shape with a rising end portion. By the rise of the end portion, the contact angle between the substrate and the end portion of the droplet becomes larger as compared to a case where the flow of the droplet is not induced, and therefore, the spreading speed of the droplet increases.

According to an example to be described later, for example, a case where the solvent (d) is a highly volatile solvent, the volume ratio of nonvolatile components is 20%, and the droplet pitch is 88 μm, that is, the average initial liquid film thickness is 13 nm or more is selected. In this case, as schematically shown in Fig. 1[3], it is indicated by numerical calculation that the droplets of the curable composition (A) bond to each other on the substrate, and a practically continuous liquid film is formed. Also, this means that the droplets of the curable composition (A) having a volume of 1.0 pL or more are arranged at a density of 130 droplets/$mm^2$ or more.

A flow behavior during the waiting step of the droplets of the curable composition (A) arranged on the substrate will be explained next with reference to Figs. 4[1] to 4[4]. The droplets of the curable composition (A) are discretely arranged on the substrate, as shown in Fig. 4[1], and each droplet gradually spreads on the substrate, as shown in Fig. 4[2]. Then, the droplets of the curable composition (A) on the substrate begin bonding to each other to form a liquid film, as shown in Fig. 4[3], and a continuous liquid film is formed (the surface of the substrate is covered with the curable composition (A) and there is no more exposed surface), as shown in Fig. 4[4]. The state of the curable composition (A) as shown in Fig. 4[4] is sometimes called "a practically continuous liquid film" hereinafter.

In addition, as schematically shown in Fig. 1[4], a solvent (d) contained in a liquid film is volatilized in the waiting step. Assuming that the total weight of the components except for the solvent (d) is 100 vol%, the residual amount of the solvent (d) in the liquid film after the waiting step (for example, at the start of the contact step) is preferably 10 vol% or less. If the residual amount of the solvent (d) is larger than 10 vol%, the mechanical properties of the cured film may deteriorate.

In the waiting step, it is possible to perform a baking step of heating the substrate and the curable composition (A), or ventilate the atmospheric gas around the substrate, for the purpose of accelerating the volatilization of the solvent (d). Heating is performed at, for example, 30°C or more and 200°C or less, preferably 80°C or more and 150°C or less, and particularly preferably 90°C or more and 110°C or less. The heating time can be 10 sec or more and 600 sec or less. The baking step can be performed by using a known heater such as a hotplate or an oven.

The time of the waiting step is, for example, 0.1 to 600 sec, and preferably 10 to 300 sec. If the waiting step is shorter than 0.1 sec, the bonding of the droplets of the curable composition (A) becomes insufficient, so no practically continuous liquid film is formed. If the waiting step exceeds 600 sec, the productivity decreases. To suppress the decrease in productivity, therefore, it is also possible to sequentially move substrates completely processed in the arranging step to the waiting step, perform the waiting step in parallel to a plurality of substrates, and sequentially move the substrates completely processed in the waiting step to the contact step. Note that in the conventional technique, a few thousands of seconds to a few tens of thousands of seconds are theoretically required before a practically continuous liquid film is formed. In practice, however, no continuous liquid film can be formed because the spread of the droplets of the curable composition stagnates due to the influence of volatilization.

When the solvent (d) volatilizes in the waiting step, the practically continuous liquid film containing the components (a), (b), and (c) remains. The average residual liquid film thickness of the practically continuous liquid film from which the solvent (d) volatilized (was removed) becomes smaller than the liquid film by the volatilized amount of the solvent (d). A state in which the entire pattern formation region of the substrate is covered with the practically continuous liquid film of the curable composition (A) from which the solvent (d) was removed is maintained in the entire region.

<Contact Step>

In the contact step, as schematically shown in Fig. 1[5], the mold is brought into contact with the practically continuous liquid film of the curable composition (A) from which the solvent (d) is removed. The contact step includes a step

of changing a state in which the curable composition (A) and the mold are not in contact with each other to a state in which they are in contact with each other, and a step of maintaining the state in which they are in contact with each other. As a consequence, the liquid of the curable composition (A) is filled in concave portions of fine patterns on the surface of the mold, and the liquid forms a liquid film filled in the fine patterns of the mold.

According to the embodiment of the present invention, the curable composition (A) forms the practically continuous liquid film from which the solvent (d) is removed in the waiting step, so the volume of a gas trapped between the mold and the substrate becomes small. Accordingly, spreading of the curable composition (A) in the contact step is rapidly completed. Fig. 5 shows comparison (difference) between a contact step in the conventional technique (related art) disclosed in PTL 1 or the like and a contact step according to this embodiment. Fig. 5 shows the contact step in the conventional technique (related art) and the contact step according to this embodiment.

When spreading and filling of the curable composition (A) are quickly completed in the contact step, it is possible to shorten the time (the time required for the contact step) for maintaining the state in which the mold is in contact with the curable composition (A). Since shortening the time required for the contact step leads to shortening the time required for pattern formation (film formation), the productivity improves. The contact step is preferably 0.1 sec or more and 3 sec or less, and particularly preferably 0.1 sec or more and 1 sec or less. If the contact step is shorter than 0.1 sec, spreading and filling become insufficient, so many defects called incomplete filling defects tend to occur.

When the curing step includes a light irradiation step, a mold made of a light-transmitting material is used as the mold by taking this into consideration. Favorable practical examples of the type of the material forming the mold are glass, quartz, PMMA, a photo-transparent resin such as a polycarbonate resin, a transparent metal deposition film, a soft film such as polydimethylsiloxane, a photo-cured film, and a metal film. When using the photo-transparent resin as the material forming the mold, a resin that does not dissolve in components contained in a curable composition is selected. Quartz is suitable as the material forming the mold because the thermal expansion coefficient is small and pattern distortion is small.

A pattern formed on the surface of the mold has a height of, for example, 4 nm or more and 200 nm or less. As the pattern height of the mold decreases, it becomes possible to decrease the force of releasing the mold from the cured film of the curable composition, that is, the mold release force in the mold release step, and this makes it possible to decrease the number of mold release defects remaining in the mold because the pattern of the curable composition is torn off. Also, in some cases, the pattern of the curable composition elastically deforms due to the impact when the mold is released, and adjacent pattern elements come in contact with each other and adhere to each other or break each other. Note that to avoid these inconveniences, it is advantageous to make the height of pattern elements be about twice or less the width of the pattern elements (make the aspect ratio be 2 or less). On the other hand, if the height of pattern elements is too small, the processing accuracy of the substrate decreases.

A surface treatment can also be performed on the mold before performing the contact step, in order to improve the detachability of the mold with respect to the curable composition (A). An example of this surface treatment is to form a mold release agent layer by coating the surface of the mold with a mold release agent. Examples of the mold release agent to be applied on the surface of the mold are a silicon-based mold release agent, a fluorine-based mold release agent, a hydrocarbon-based mold release agent, a polyethylene-based mold release agent, a polypropylene-based mold release agent, a paraffin-based mold release agent, a montane-based mold release agent, and a carnauba-based mold release agent. It is also possible to suitably use a commercially available coating-type mold release agent such as Optool® DSX manufactured by Daikin. Note that it is possible to use one type of a mold release agent alone, or use two or more types of mold release agents together. Of the mold release agents described above, fluorine-based and hydrocarbon-based mold release agents are particularly favorable.

In the contact step, the pressure to be applied to the curable composition (A) when bringing the mold into contact with the curable composition (A) is not particularly limited, and is, for example, 0 MPa or more and 100 MPa or less. Note that when bringing the mold into contact with the curable composition (A), the pressure to be applied to the curable composition (A) is preferably 0 MPa or more and 50 MPa or less, more preferably 0 MPa or more and 30 MPa or less, and further preferably 0 MPa or more and 20 MPa or less.

The contact step can be performed in any of a normal air atmosphere, a reduced-pressure atmosphere, and an inert-gas atmosphere. However, the reduced-pressure atmosphere or the inert-gas atmosphere is favorable because it is possible to prevent the influence of oxygen or water on the curing reaction. Practical examples of an inert gas to be used when performing the contact step in the inert-gas atmosphere are nitrogen, carbon dioxide, helium, argon, various freon gases, and gas mixtures thereof. A gas containing 10% or more of carbon dioxide or helium in a molar ratio is preferable, and a gas containing 10% or more of carbon dioxide in a molar ratio is particularly preferable. Since the helium gas readily diffuses to the mold, the substrate, the curable composition, and the like, the atmospheric gas confined in the mold pattern quickly disappears. Since carbon dioxide readily dissolves to the curable composition or the underlayer on the substrate, the atmospheric gas confined in the mold pattern quickly disappears. The solubility coefficient of carbon dioxide to the curable composition is preferably 0.5 $kg/m^3 \cdot atm$ or more and 10 $kg/m^3 \cdot atm$ or less. Details are disclosed in Japanese Patent Laid-Open No. 2022-99271 (PTL 5). When performing the contact step in a specific gas atmosphere including a normal air atmosphere, a favorable pressure is 0.0001 atm or more and 10 atm or less.

<Curing Step>

In the curing step, as schematically shown in Fig. 1[6], the curable composition (A) is cured by being irradiated with irradiation light as curing energy, thereby forming a cured film. In the curing step, for example, the curable composition (A) is irradiated with the irradiation light through the mold. More specifically, the curable composition (A) filled in the fine pattern of the mold is irradiated with the irradiation light through the mold. Consequently, the curable composition (A) filled in the fine pattern of the mold is cured and forms a cured film having the pattern.

The irradiation light is selected in accordance with the sensitivity wavelength of the curable composition (A). More specifically, the irradiation light is properly selected from ultraviolet light, X-ray, and an electron beam each having a wavelength of 150 nm or more and 400 nm or less. Note that the irradiation light is particularly preferably ultraviolet light. This is so because many compounds commercially available as curing assistants have sensitivity to ultraviolet light. Examples of a light source that emits ultraviolet light are a high-pressure mercury lamp, an ultrahigh-pressure mercury lamp, a low-pressure mercury lamp, a Deep-UV lamp, a carbon arc lamp, a metal halide lamp, a xenon lamp, a KrF excimer laser, an ArF excimer laser, and an $F_2$ laser. Note that the ultrahigh-pressure mercury lamp is particularly favorable as the light source for emitting ultraviolet light. It is possible to use one light source or a plurality of light sources. Light can be emitted to the entire region of the curable composition (A) filled in the fine pattern of the mold, or to only a partial region thereof (by limiting the region). It is also possible to intermittently emit light to the entire region of the substrate a plurality of times, or to continuously emit light to the entire region of the substrate. Furthermore, a first region of the substrate can be irradiated with light in a second irradiation process, and a second region different from the first region of the substrate can be irradiated with light in a second irradiation process.

<Mold Release Step>

In the mold release step, as schematically shown in Fig. 1[7], the mold is released from the cured film. When the mold is released from the cured film having the pattern, the cured film having a pattern formed by inverting the fine pattern of the mold is obtained in an independent state. In this state, a cured film remains in concave portions of the cured film having the pattern. This film is called a residual film.

A method of releasing the mold from the cured film having the pattern can be any method provided that the method does not physically break a part of the cured film having the pattern during the release, and various conditions and the like are not particularly limited. For example, it is possible to fix the substrate and move the mold away from the substrate. It is also possible to fix the mold and move the substrate away from the mold. Furthermore, the mold can be released from the cured film having the pattern by moving both the mold and the substrate in exactly opposite directions.

<Repetition>

A series of steps (a fabrication process) having the above-described steps from the arranging step to the mold release step in this order make it possible to obtain a cured film having a desired concave-convex pattern shape (a pattern shape conforming to the uneven shape of the mold) in a desired position.

In the above-described pattern forming method, a repetition unit (shot) from the arranging step to the mold release step can repetitively be performed a plurality of times on the same substrate, so the cured film having a plurality of desired patterns in desired positions of the substrate can be obtained.

[Planarization Film Forming Method]

An example in which the film forming method according to the embodiment of the present invention is applied to a planarization film forming method will be explained below. The planarization film forming method includes, for example, an arranging step, a waiting step, a contact step, a curing step, and a mold release step. The arranging step is a step of arranging droplets of the curable composition (A) on a substrate. The waiting step is a step of waiting until the droplets of the curable composition (A) bond to each other and the solvent (d1) volatilizes. The contact step is a step of bringing the curable composition (A) and a mold into contact with each other. The curing step is a step of curing the curable composition (A). The mold release step is a step of releasing the mold from the cured film of the curable composition (A). In the planarization film forming method, a substrate having unevenness having a difference in height of about 10 to 1,000 nm is used as the substrate, a mold having a flat surface is used as the mold, and a cured film having a surface conforming to the flat surface of the mold is formed through the contact step, the curing step, and the mold release step. In the arranging step, the droplets of the curable composition (A) are densely arranged in concave portions of the substrate, and sparsely arranged on convex portions of the substrate. The waiting step is performed after the arranging step, the contact step is performed after the waiting step, the curing step is performed after the contact step, and the mold release step is performed after the curing step.

[Article Manufacturing Method]

An article manufacturing method according to this embodiment includes a forming step of forming a film of a curable composition on a substrate using the above-described film forming method, a processing step of processing the substrate on which the film of the curable composition is formed in the forming step, and a manufacturing step of manufacturing an article from the substrate processed in the processing step. The film forming method can be a pattern forming method or a planarization film forming method, as described above.

A cured film having a pattern formed by the pattern forming method according to the embodiment of the present invention is directly used as at least a partial constituent member of various kinds of articles. Alternatively, a cured film having a pattern formed by the pattern forming method according to the embodiment of the present invention is temporarily used as a mask for etching or ion implantation with respect to a substrate (a layer to be processed when the substrate has the layer to be processed). This mask is removed after etching or ion implantation is performed in a substrate processing step. Consequently, various kinds of articles can be manufactured.

When removing a cured product in concave portions of a pattern of the cured product by etching, a practical method is not particularly limited, and a conventionally known method such as dry etching can be used. A conventionally known dry etching apparatus can be used in this dry etching. A source gas for dry etching is appropriately selected in accordance with an element composition of the cured product to be etched. As the source gas, it is possible to use halogen gases such as $CF_4$, $C_2F_6$, $C_3F_8$, $CCl_2F_2$, $CCl_4$, $CBrF_3$, $BCl_3$, $PCl_3$, $SF_6$, and $Cl_2$, gases containing oxygen atoms such as $O_2$, CO, and $CO_2$, inert gases such as He, $N_2$, and Ar, and gases such as $H_2$ and $NH_3$. Note that these gases can also be used as a gas mixture. In this case, the photo-cured film is required to have a high dry etching resistance in order to process the base substrate with high yield.

An article is, for example, an electric circuit element, an optical element, MEMS, a recording element, a sensor, or a mold. Examples of the electric circuit element are volatile or nonvolatile semiconductor memories such as a DRAM, an SRAM, a flash memory, and an MRAM, and semiconductor elements such as an LSI, a CCD, an image sensor, and an FPGA. Examples of the optical element are a micro lens, a light guide body, a waveguide, an antireflection film, a diffraction grating, a polarizer, a color filter, a light-emitting element, a display, and a solar battery. Examples of the MEMS are a DMD, a microchannel, and an electromechanical transducer. Examples of the recording element are optical disks such as a CD and a DVD, a magnetic disk, a magneto-optical disk, and a magnetic head. Examples of the sensor are a magnetic sensor, a photosensor, and a gyro sensor. An example of the mold is a mold for imprinting.

In addition, a well-known photolithography step such as an imprint lithography technique or an extreme ultraviolet exposure technique (EUV) can be performed on the planarization film formed by the planarization film forming method according to the embodiment of the present invention. It is also possible to stack a spin-on-glass (SOG) film and/or a silicon oxide layer, and perform a photolithography step by applying a curable composition on that. Consequently, a device such as a semiconductor device can be fabricated. It is further possible to form an apparatus including the device, for example, an electronic apparatus such as a display, a camera, or a medical apparatus. Examples of the device are an LSI, a system LSI, a DRAM, an SDRAM, an RDRAM, a D-RDRAM, and a NAND flash memory.

[Examples]

To supplement the above-described embodiment, more detailed examples will be described.

<Example 1>

In Example 1, it is indicated by numerical calculation that when $\gamma$1 is larger than y2, a dropped droplet largely spreads (that is, the spreading speed of the droplet increases) and a solvent volatilizes quickly. Note that as described above, $\gamma$1 is the surface tension of a curable composition at 23°C in a state in which a solvent (d) is removed, and y2 is the surface tension of the solvent (d) at 23°C.

Droplets of 1 pL were arranged on a flat substrate under an initial condition of a contact angle of 90°, and how the droplets spread while volatilizing was obtained by solving Navier-Stokes equations that had undergone thin-film approximation (lubrication theory) with a free surface. The droplet was a two-component fluid containing a nonvolatile component and a volatile component, and the volume ratio of the nonvolatile component under the initial condition was 20%. As for the nonvolatile component, the molecular weight was 300 g/mol, the viscosity was 150 cP, and the surface tension (y1) was 35 mN/m. As for the volatile component, the molecular weight was 125 g/mol, the viscosity was 1.1 cP, and the surface tension (y2) was set to 30, 34, 34.9, and 35 mN/m to do calculation. The viscosity and the surface tension of the curable composition change along with the progress of volatilization. As for the function of the volume ratio of the nonvolatile component, the viscosity was interpolated by an exponential function, and the surface tension was interpolated by a linear function. Also, the calculation was ended when the volatilization was completed.

For the spreading of the droplets, it was assumed that a thin film existed as a preparatory film and the volume ratio

of the nonvolatile component of the preparatory thin film was equal to that at the droplet end portion.

Volatilization was taken into consideration as the source term of the time-rate change of the height function of the droplet, which was proportional to the molar fraction of the volatile component, and was modelized as an even distribution in the spatial direction. As the proportionality coefficient, $10^{-8}$ m/sec was used. The diffusion coefficient of concentration diffusion of the nonvolatile component was obtained by the Wilke-Chang Equation, and the dependence of the nonvolatile component on the concentration was interpolated by an exponential function.

Fig. 6 shows the time-rate change of the droplet radius. The abscissa indicates elapsed time [sec], and the ordinate indicates the radius [m] of the droplet. $\Delta\gamma$ defined by equation (3) below changes between curves. $\Delta\gamma = 0$ in 501, $\Delta\gamma = 0.1$ in 502, $\Delta\gamma = 1$ in 503, and $\Delta\gamma = 5$ in 504. According to this result, it is found that the maximum radius of the droplet is larger and time needed to complete volatilization is short when $\Delta\gamma > 0$ than when $\Delta\gamma = 0$. It is also found that the larger $\Delta\gamma$ is, the larger the maximum radius of the droplet is and the shorter the time needed to complete volatilization is.

$$\Delta\gamma: = \gamma 1 - \gamma 2 \qquad \text{...(3)}$$

Fig. 7 shows the dependence of the maximum radius of the droplet on $\Delta\gamma$. The abscissa indicates $\Delta\gamma$ [mN/m], and the ordinate indicates $\Delta r$ [$\mu$m]. Here, $\Delta r$ is defined by equation (4) below. In equation (4), r is the maximum radius of the droplet, and $r_0$ is the maximum radius of the droplet when $\Delta\gamma = 0$. As is apparent from Fig. 7, $\Delta r$ monotonically increases along with the change of $\Delta\gamma$. It is found that if $\Delta\gamma > 0.1$ mN/m, $\Delta r > 1$ $\mu$m, that is, the droplet spreads more than when $\Delta\gamma = 0$. Furthermore, it is found that if $\Delta\gamma > 1$ mN/m, $\Delta r > 10$ $\mu$m, that is, the droplet spreads more conspicuously than when $\Delta\gamma = 0$.

$$\Delta r: = r - r_0 \qquad \text{...(4)}$$

Fig. 8 shows the dependence of the volatilization time on $\Delta\gamma$. The abscissa indicates $\Delta\gamma$ [mN/m], and the ordinate indicates Rt. Here, Rt is defined by equation (5) below. In equation (5), t is the volatilization time of the droplet, and $t_0$ is the volatilization time of the droplet when $\Delta\gamma = 0$. As is apparent from Fig. 8, Rt monotonically decreases along with the change of $\Delta\gamma$. It is found that if $\Delta\gamma > 0.1$ mN/m, $Rt < 0.85$, that is, the time needed to complete volatilization is shorter than when $\Delta\gamma = 0$. It is found that if $\Delta\gamma > 1$ mN/m, $Rt < 0.6$, that is, the time needed to complete volatilization is conspicuously shorter than when $\Delta\gamma = 0$.

$$Rt: = t/t_0 \qquad \text{...(5)}$$

As is apparent from the above-described results, the maximum radius of the droplet is larger and the time needed to complete volatilization is shorter when $\Delta\gamma > 0$ than when $\Delta\gamma = 0$. Also, to obtain the effects on the maximum radius of the droplet and the time needed to complete volatilization, preferably, $\Delta\gamma > 0.1$ mN/m is desirable, and more preferably, $\Delta\gamma > 1$ mN/m is desirable.

<Example 2>

In Example 2, it is indicated by numerical calculation that when $\gamma 1$ is larger than y2, a thinner cured film can be formed.

In general, if the interval of arranged droplets is small, the droplets bond to each other to form a continuous liquid film, and if the interval of droplets is large, the droplets cannot bond to each other, and a continuous liquid film cannot be formed. The maximum value of the droplet interval, which enables to form a continuous liquid film until volatilization completion will be referred to as a droplet critical pitch hereinafter. As described in Example 1 above, the maximum radius of the droplet until volatilization completion is larger when $\Delta\gamma > 0$ than when $\Delta\gamma = 0$. This suggests that the droplet critical pitch is larger when $\Delta\gamma > 0$ than when $\Delta\gamma = 0$.

Under an initial condition that droplets were arranged in a square array, numerical calculation was performed in accordance with the same procedure as in Example 1 described above, thereby checking the droplet critical pitch. The results are shown in Tables 1 and 2 below. In each table, whether a continuous liquid film can be formed until volatilization completion is indicated for each droplet pitch in each of a case where $\Delta\gamma = 0$ and a case where $\Delta\gamma = 5$. In each table, "OK" indicates that a continuous liquid film can be formed, and "NG" indicates that a continuous liquid film cannot be formed. Note that Table 1 shows the result of a highly volatile solvent for which the proportionality coefficient of volatilization is about $5 \times 10^{-8}$ m/sec, and Table 2 shows the result of a low volatile solvent for which the proportionality coefficient of volatilization is about $7 \times 10^{-10}$ m/sec.

[Table 1]

| highly volatile materials | droplet pitch [μm] | | | |
|---|---|---|---|---|
| Δγ [mN/m] | 56 | 63 | 88 | 94 |
| 0 | OK | NG | NG | NG |
| 5 | OK | OK | OK | NG |

[Table 2]

| low volatile materials | droplet pitch [μm] | | | |
|---|---|---|---|---|
| Δγ [mN/m] | 88 | 94 | 119 | 125 |
| 0 | OK | NG | NG | NG |
| 5 | OK | OK | OK | NG |

According to Table 1, in a case of the highly volatile solvent, it is found that the droplet critical pitch when Δγ = 0 is from 56 μm to 63 μm, and the droplet critical pitch when Δγ = 5 is from 88 μm to 94 μm. It is thus found that the droplet critical pitch is larger when Δγ > 0 than when Δγ = 0. The droplet pitch of 56 μm indicates a film thickness of 63 nm, and the droplet pitch of 88 μm indicates a film thickness of 26 nm. It is found that a thinner cured film can be formed when Δγ > 0 than when Δγ = 0.

According to Table 2, in a case of the low volatile solvent, it is found that the droplet critical pitch when Δγ = 0 is from 88 μm to 94 μm, and the droplet critical pitch when Δγ = 5 is from 119 μm to 125 μm. It is thus found that the droplet critical pitch is larger when Δγ > 0 than when Δγ = 0. The droplet pitch of 88 μm indicates a film thickness of 26 nm, and the droplet pitch of 119 μm indicates a film thickness of 14 nm. It is found that a thinner cured film can be formed when Δγ > 0 than when Δγ = 0.

<Evaluation of Inkjet Discharge Property and Filling Property>

In accordance with Table 3 below, the curable composition (A) was mixed such that the sum of the monofunctional polymerizable compound (a), the polyfunctional polymerizable compound (a), the photopolymerization initiator (b), and the solvent (d) became 100 wt%. Abbreviations in Table 4 and various kinds of physical property values of individual materials are shown in Tables 4 and 5. The viscosities at 23°C of the curable composition (A) and the curable composition (A) mixed without using the solvent (d) were measured. In addition, the OP of the polymerizable compound (a) {the sum of the monofunctional compound and the polyfunctional compound} in a state in which the solvent (d) was removed (at the time of solvent removal) was calculated by the above-described method. Furthermore, the glass transition temperature of the curable composition after curing was measured. The result is shown in Table 6. In addition, details of photopolymerization initiators used in Table 3 are shown below.

· <<Photopolymerization Initiator (b)>>
Omnirad 819: phenylbis(2,4,6-trimethylbenzoyl)phosphine oxide (manufactured by IGM Resin)
· <<Surfactant>>

S1: MEGAFACE F-444 (manufactured by DIC)
S2: ADEKA® NOL L-44 (manufactured by ADEKA)

[Table 3]

| | Polymerizable compound (a) | | | | Polymerization initiator (b) | | Surfactant (c) | | Solvent (d) | |
|---|---|---|---|---|---|---|---|---|---|---|
| | Polymerizable monomer (monofunctional) Polymerizable monomer (polyfunctional) | | | | | | | | | |
| | name | amount | name | amount | type | amount | type | amount | type | amount |
| Example 3 | monofunctional organic monomer (d) | 7 | polyfunctional organic monomer (A) | 13 | Omnirad819 | 1.0 | - | 0 | BzA | 79.0 |
| Example 4 | monofunctional organic monomer (d) | 7 | polyfunctional organic monomer (A) | 13 | Omnirad819 | 1.0 | S2 | 1.0 | PGMEA | 780 |
| Example 5 | monofunctional organic monomer (d) | 7 | polyfunctional organic monomer (A) | 13 | Omnirad819 | 1.0 | - | 0 | PGMEA | 79.0 |
| Example 6 | monofunctional organic monomer (d) | 10 | polyfunctional organic monomer (A) | 13 | Omnirad819 | 1.0 | - | 0 | NMP | 76.0 |
| Example 7 | monofunctional organic monomer (d) | 16 | polyfunctional organic monomer (A) | 13 | Omnirad819 | 1.0 | - | 0 | PGMEA | 70.0 |
| Example 8 | monofunctional organic monomer (a) | 4 | polyfunctional organic monomer (A) | 16 | Omnirad819 | 1.0 | - | 0 | BzA | 79.0 |
| Example 9 | monofunctional organic monomer (b) | 7 | polyfunctional organic monomer (A) | 13 | Omnirad819 | 1.0 | - | 0 | PGMEA | 79.0 |
| Example 10 | monofunctional organic monomer (c) | 7 | polyfunctional organic monomer (A) | 13 | Omnirad819 | 1.0 | - | 0 | PGMEA | 79.0 |
| Example 11 | monofunctional organic monomer (e) | 7 | polyfunctional organic monomer (A) | 13 | Omnirad819 | 1.0 | - | 0 | PGMEA | 79.0 |
| Example 12 | monofunctional organic monomer (e) | 10 | polyfunctional organic monomer (A) | 13 | Omnirad819 | 1.0 | - | 0 | PGMEA | 76.0 |
| Example 13 | monofunctional organic monomer (d) | 7 | polyfunctional organic monomer (B) | 13 | Omnirad819 | 1.0 | - | 0 | PGMEA | 79.0 |
| Example 14 | monofunctional organic monomer (d) | 7 | polyfunctional organic monomer (C) | 13 | Omnirad819 | 1.0 | - | 0 | PGMEA | 79.0 |
| Example 15 | monofunctional organic monomer (d) | 7 | polyfunctional organic monomer (A) | 13 | Omnirad819 | 1.0 | - | 0 | PG | 79.0 |
| Example 16 | monofunctional organic monomer (b) | 25 | polyfunctional organic monomer (B) | 65 | Omnirad820 | 1.0 | - | 1.0 | PG | 8.0 |

(continued)

| | Polymerizable compound (a) | | | | Polymerization initiator (b) | | Surfactant (c) | | Solvent (d) | |
|---|---|---|---|---|---|---|---|---|---|---|
| | Polymerizable monomer (monofunctional) Polymerizable monomer (polyfunctional) | | | | | | | | | |
| | name | amount | name | amount | type | amount | type | amount | type | amount |
| Example 17 | monofunctional organic monomer (d) | 3 | polyfunctional organic monomer (A) | 3 | Omnirad821 | 1.0 | - | 1.0 | PGMEA | 92.0 |
| Example 18 | monofunctional organic monomer (d) | 25 | - | 0 | Omnirad820 | 1.0 | - | 0 | PGMEA | 74.0 |
| Example 19 | monofunctional Si monomer (f) | 11.6 | polyfunctional organic monomer (A) | 17.4 | Omnirad819 | 1.0 | - | 0 | MIBK | 70.0 |
| Example 20 | monofunctional Si monomer (f) | 7.3 | polyfunctional organic monomer (A) | 21.8 | Omnirad819 | 1.0 | - | 0 | MIBK | 70.0 |
| Example 21 | monofunctional organic monomer (e) | 17.4 | polyfunctional Si monomer (D) | 11.6 | Omnirad819 | 1.0 | - | 0 | MIBK | 70.0 |
| Example 22 | monofunctional organic monomer (e) | 29.0 | polyfunctional Si monomer (D) | 7.3 | Omnirad819 | 1.0 | - | 0 | MIBK | 62.8 |
| Comparative Example 1 | monofunctional organic monomer (d) | 7 | polyfunctional organic monomer (A) | 13 | Omnirad819 | 1.0 | S2 | 1.0 | BzA | 78.0 |
| Comparative Example 2 | monofunctional organic monomer (d) | 7 | polyfunctional organic monomer (A) | 13 | Omnirad819 | 1.0 | S1 | 1.0 | PGMEA | 78.0 |
| Comparative Example 3 | monofunctional organic monomer (d) | 7 | polyfunctional organic monomer (A) | 13 | Omnirad819 | 1.0 | - | 0 | DEG | 79.0 |
| Comparative Example 4 | monofunctional organic monomer (d) | 13 | polyfunctional organic monomer (A) | 13 | Omnirad819 | 1.0 | - | 0 | PG | 73.0 |
| Comparative Example 5 | monofunctional organic monomer (d) | 7 | polyfunctional organic monomer (A) | 13 | Omnirad819 | 1.0 | - | 0 | Gly | 79.0 |
| Comparative Example 6 | monofunctional organic monomer (d) | 49.5 | polyfunctional organic monomer (A) | 49.5 | Omnirad819 | 1.0 | - | 0 | - | 0.0 |

[Table 4]

| Classification | Chemical structure | Manufacturer | Product name | Functional group | Viscosity (mPa·s) | Surface tension (mN/m) | OP of single material (-) | Si atom content of single material (%) |
|---|---|---|---|---|---|---|---|---|
| monofunctional organic monomer (a) | 2-phenoxyethyl acrylate | KYOEISHA CHEMICAL | Light Acrylate PO-A | 1 | 12 | 39.2 | 2.78 | 0 |
| monofunctional organic monomer (b) | tetrahydrofurfuryl acrylate | OSAKA ORGANIC CHEMICAL INDUSTRY | Viscoat #150 | 1 | 6 | 36.1 | 4.60 | 0 |
| monofunctional organic monomer (c) | isobornyl acrylate | OSAKA ORGANIC CHEMICAL INDUSTRY | IBXA | 1 | 9 | 31.7 | 3.18 | 0 |
| monofunctional organic monomer (d) | 2-(o-phenylphenoxy)ethyl acrylate | NIPPON SHOKUBAI | HRD-01 | 1 | 140 | 41.6 | 2.57 | 0 |
| monofunctional organic monomer (e) | 1-naphthalene methyl acrylate | KYOEISHA CHEMICAL | NMT-A | 1 | 30 | 43.5 | 2.33 | 0 |
| monofunctional Si monomer (f) | 3-methacryloxypropyltris(trimethylsiloxy)silane | JNC | TM-0701T | 1 | 4.5 | 21.9 | 5.73 | 26.5 |
| polyfunctional organic monomer (A) | dimethylol-tricyclodecanediacrylate | KYOEISHA CHEMICAL | Light Acrylate DCP-A | 2 | 130 | 38.6 | 3.29 | 0 |
| polyfunctional organic monomer (B) | pentaerythritol tetraacrylate | Sartomer | SR295 | 4 | 42 | 40.1 | 5.00 | 0 |
| polyfunctional organic monomer (C) | ditrimethylolpropane tetraacrylate | Sartomer | SR355 | 4 | 600 | 36 | 4.47 | 0 |
| polyfunctional Si monomer (D) | acryloyl group-modified silsesquioxane derivatives | TOAGOSEI | AC-SQ TA-100 | ≥ 2 | 6000 | 22 | | 18 |

[Table 5]

| Solvent | Name | Boiling point | Viscosity of single material (mPa·s) | Surface tension of single material (mN/m) |
|---|---|---|---|---|
| BzA | benzyl acrylate | 215 | 2.2 | 36.8 |
| PGMEA | propylene glycol monomethyl ether acetate | 146 | 1.1 | 27.6 |
| MIBK | methyl isobutyl ketone | 116 | 0.6 | 24.2 |
| DEG | diethylene glycol | 244 | 32 | 42.1 |
| NMP | N-methylpyrrolidone | 202 | 1.9 | 33.8 |
| Gly | glycerin | 290 | 1389.0 | 62 |
| PG | propylene glycol | 188 | 48.6 | 38 |

[Table 6]

| | Initial viscosity (23°C)/mPa·s | Solvent content (%) | Boiling point of solvent | γ1 - γ2/mN/m | Viscosity when solvent was removed (23°C)/mPa·s | Ratio of polyfunctional monomer in monomer (%) | Glass transition temperature of cured product (°C) |
|---|---|---|---|---|---|---|---|
| Example 3 | 5.0 | 79 | 215 | 2.94 | 133.4 | 65.0 | 135 |
| Example 4 | 2.9 | 78 | 146 | 8.40 | 133.4 | 65.0 | 135 |
| Example 5 | 2.9 | 79 | 146 | 12.14 | 133.4 | 65.0 | 135 |
| Example 6 | 5.1 | 76 | 202 | 6.20 | 134.3 | 56.5 | 122 |
| Example 7 | 4.5 | 70 | 146 | 12.75 | 135.4 | 44.8 | 103 |
| Example 8 | 4.6 | 79 | 215 | 1.97 | 80.7 | 80.0 | 153 |
| Example 9 | 2.3 | 79 | 146 | 9.72 | 44.3 | 65.0 | 118 |
| Example 10 | 2.4 | 79 | 146 | 7.96 | 51.1 | 65.0 | 154 |
| Example 11 | 2.6 | 79 | 146 | 13.14 | 77.8 | 65.0 | 134 |
| Example 12 | 2.9 | 76 | 146 | 13.57 | 68.7 | 56.5 | 120 |
| Example 13 | 2.5 | 79 | 146 | 13.12 | 64.0 | 65.0 | 79 |
| Example 14 | 3.5 | 79 | 146 | 11.11 | 360.5 | 65.0 | 75 |
| Example 15 | 59.6 | 79 | 188 | 1.74 | 133.4 | 65.0 | 135 |
| Example 16 | 25.9 | 8 | 188 | 0.24 | 24.5 | 72.2 | 70 |
| Example 17 | 1.5 | 92 | 146 | 12.59 | 134.9 | 50.0 | 112 |
| Example 18 | 3.7 | 74 | 146 | 14.00 | 140.0 | 0.0 | 33 |
| Example 19 | 2.0 | 70 | 116 | 8.98 | 33.9 | 60.0 | 150 |
| Example 20 | 2.3 | 70 | 116 | 11.17 | 56.1 | 75.0 | 165 |
| Example 21 | 3.5 | 70 | 116 | 0.10 | 249.8 | 40.0 | 118 |
| Example 22 | 3.7 | 62.75 | 116 | 2.20 | 86.6 | 20.0 | 74 |
| Comparative Example 1 | 5.1 | 78 | 215 | -0.80 | 133.4 | 65.0 | 135 |
| Comparative Example 2 | 2.9 | 78 | 146 | -6.50 | 133.4 | 65.0 | 135 |
| Comparative Example 3 | 42.7 | 79 | 244 | -2.36 | 133.4 | 65.0 | 135 |

(continued)

| | Initial viscosity (23°C)/mPa·s | Solvent content (%) | Boiling point of solvent | γ1 - γ2/mN/m | Viscosity when solvent was removed (23°C)/mPa·s | Ratio of polyfunctional monomer in monomer (%) | Glass transition temperature of cured product (°C) |
|---|---|---|---|---|---|---|---|
| Comparative Example 4 | 63.5 | 73 | 188 | 2.19 | 134.9 | 50.0 | 112 |
| Comparative Example 5 | 865.3 | 79 | 290 | -22.26 | 133.4 | 65.0 | 135 |
| Comparative Example 6 | 134.9 | 0 | - | - | 134.9 | 0.5 | 112 |

<Evaluation of Inkjet Discharge>

For inkjet discharge evaluation, a commercially available industrial material printer DMP-2850 (manufactured by Fujifilm) was used. Examples 3 to 22 and Comparative Examples 1 to 6 obtained in Table 3 were filled in 1-pL cartridges. Discharge states were observed by an internal discharge observation camera, and evaluation was done based on the following determination criteria.

(Evaluation Criteria)

AAA: At a flying speed of 11 m/sec or more, no distortion was observed at all.
AA: At a flying speed of 11 m/sec or more, very slight distortion without practical influence was observed.
A: At a flying speed of 10 m/sec or more, very slight distortion without practical influence was observed.
B: Discharge was not performed.

<Evaluation of Filling Property>

Under a condition that the thickness of a liquid film before volatilization of the solvent (d) was 80 nm, each of the curable compositions (A) of Examples 3 to 22 and Comparative Examples 1 to 6 was discretely dropped (arranged) on a silicon substrate. Time until a practically continuous liquid film was formed was measured, and the filling property was evaluated based on the following determination criteria.

(Evaluation Criteria)

AAA: A practically continuous liquid film was formed in a time less than 100 sec.
AA: A practically continuous liquid film was formed in a time of 100 sec or more and less than 200 sec.
A: A practically continuous liquid film was formed in a time of 200 sec or more and less than 300 sec.
B: A practically continuous liquid film was not formed even after the elapse of time of 300 sec.

<Evaluation of Pattern Collapse>

The arranging step, the waiting step, the contact step, the curing step, and the mold release step were executed for each of the curable compositions (A) of Examples 3 to 22 and Comparative Examples 1 to 6 using a quartz mold with a line-and-space (L/S) pattern having a depth of 50 nm and a width of 20 nm and formed on the entire region. Patterns obtained by these steps were observed and evaluated based on the following determination criteria.

(Evaluation Criteria)

AAA: Pattern collapse was observed in a region less than 0.5% the pattern formation region.
AA: Pattern collapse was observed in a region less than 1% the pattern formation region.
A: Pattern collapse was observed in a region less than 10% the pattern formation region.
B: Pattern collapse was observed in a region 10% or more the pattern formation region.

<Evaluation of Dry Etching Resistance>

Cured films obtained in Examples 3 to 18 and Comparative Examples 1 to 6 were exposed to oxygen plasma in a dry etching apparatus. In addition, cured films obtained in Examples 19 to 22 were exposed to $CF_4$ plasma in a dry etching apparatus. A weight change of a film remaining in each example was measured and evaluated based on the following determination criteria.

(Evaluation Criteria)

AAA: The weight of a remaining cured film was 46% or more the weight before etching.
AA: The weight of a remaining cured film was 42% or more the weight before etching.
A: The weight of a remaining cured film was 38% or more the weight before etching.
B: The weight of a remaining cured film was less than 38% the weight before etching.

Table 7 shows the above-described evaluation results. It is found that if the viscosity of the curable composition at 23°C is 1.3 mPa·s or more and 60 mPa·s or less, the inkjet discharge is excellent. It is found that if the viscosity of the curable composition at 23°C is preferably 3 mPa·s or more and 30 mPa·s or less, and further preferably 5 mPa·s or more and 15 mPa·s or less, the inkjet discharge is more excellent. It is found that if the surface tension $\gamma 1$ (mN/m) of the curable composition in a state in which the solvent is removed is larger than the surface tension y2 of the solvent, the inkjet filling property is excellent. It is found that $\Delta\gamma = \gamma 1 - \gamma 2 > 0.1$ (mN/m) is preferable, $\Delta\gamma = \gamma 1 - \gamma 2 > 1.0$ (mN/m) is further preferable, and $\Delta\gamma = \gamma 1 - \gamma 2 > 2.0$ (mN/m) is more preferable.
If the glass transition temperature of the cured curable composition after curing was 130°C or more, pattern collapse was observed in a region less than 0.5% the pattern formation region. If the glass transition temperature was 100°C or more and less than 130°C, pattern collapse was observed in a region less than 1% the pattern formation region. If the glass transition temperature was 70°C or more and less than 100°C, pattern collapse was observed in a region less than 10% the pattern formation region. If the glass transition temperature was less than 70°C, pattern collapse was observed in a region 10% or more the pattern formation region. In all cases, the degree of pattern collapse was very slight.
Also, in Examples 3 to 18 and Comparative Examples 1 to 6, if the OP of the polymerizable compound (a) is 2.50 or more and 3.00 or less, the weight of the remaining cured film is 46% that before etching. If the OP of the polymerizable compound (a) is 3.00 or more and less than 3.50, 42% or more the curable composition remained as the cured film, and if the OP of the polymerizable compound (a) is 3.50 or more and 4.00 or less, 38% or more of the curable composition remained as the cured film. If the curable composition (A) of each of Examples 19 to 22 contained 10 wt% or more of Si atoms in a state in which the solvent (d) was removed, 38% or more of the curable composition remained as the cured film.

[Table 7]

| | Evaluation result | | | |
|---|---|---|---|---|
| | IJ discharge | filling property | pattern collapse | DE resistance |
| Example 3 | AAA | AAA | AAA | AA |
| Example 4 | AA | AAA | AAA | AA |
| Example 5 | AA | AAA | AAA | AA |
| Example 6 | AAA | AAA | AA | AAA |
| Example 7 | AA | AAA | AA | AAA |
| Example 8 | AA | AA | AAA | AA |
| Example 9 | AA | AAA | AA | A |
| Example 10 | AA | AAA | AAA | AA |
| Example 11 | AA | AAA | AAA | AAA |

(continued)

| | Evaluation result | | | |
|---|---|---|---|---|
| | IJ discharge | filling property | pattern collapse | DE resistance |
| Example 12 | AA | AAA | AA | AAA |
| Example 13 | AA | AAA | A | A |
| Example 14 | AA | AAA | A | A |
| Example 15 | A | AA | AAA | AA |
| Example 16 | AA | A | A | B |
| Example 17 | A | AAA | AA | AAA |
| Example 18 | AA | AAA | B | AAA |
| Example 19 | A | AAA | AAA | A |
| Example 20 | AA | AAA | AAA | B |
| Example 21 | AA | A | AA | B |
| Example 22 | AA | AAA | A | B |
| Comparative Example 1 | AAA | B | AAA | AA |
| Comparative Example 2 | AA | B | AAA | AA |
| Comparative Example 3 | A | B | AAA | AA |
| Comparative Example 4 | B | AAA | AA | AAA |
| Comparative Example 5 | B | B | AAA | AA |
| Comparative Example 6 | B | AAA | AA | AAA |

The present invention is not limited to the above embodiments and various changes and modifications can be made within the spirit and scope of the present invention. Therefore, to apprise the public of the scope of the present invention, the following claims are made.

This application claims priority from Japanese Patent Application No. 2022-190577 filed November 29, 2022 and Japanese Patent Application No. 2023-163584 filed September 26, 2023, which are hereby incorporated by reference herein.

## Claims

1. A curable composition containing at least a polymerizable compound (a), a photopolymerization initiator (b), and a solvent (d), **characterized in that**

   a viscosity of the curable composition at 23°C is not less than 1.3 mPa·s and not more than 60 mPa·s,
   a content of the solvent (d) with respect to the whole curable composition is larger than 5 vol% and not more than 95 vol%,
   a boiling point of the solvent (d) is less than 250°C, and
   letting $\gamma1$ (mN/m) be a surface tension of the curable composition at 23°C in a state in which the solvent (d) is removed, and y2 (mN/m) be a surface tension of the solvent (d) at 23°C, $\gamma1$ is larger than y2.

2. The curable composition according to claim 1, **characterized in that** $\Delta\gamma = \gamma1 - \gamma2 > 0.1$ (mN/m).

3. The curable composition according to claim 1, **characterized in that** $\Delta\gamma = \gamma1 - \gamma2 > 1$ (mN/m).

4. The curable composition according to claim 1, **characterized in that** the curable composition in the state in which the solvent (d) is removed has a viscosity of not less than 30 mPa·s and not more than 10.000 mPa·s at 23°C.

5. The curable composition according to claim 1, **characterized in that** the solvent (d) contains not less than one type of solvent, and the boiling point of each of the not less than one type of solvent at normal pressure is not less than 100°C

and less than 250°C.

6. The curable composition according to claim 1, **characterized in that** the solvent (d) contains a polymerizable compound whose boiling point at normal pressure is not less than 100°C and less than 250°C.

7. The curable composition according to claim 1, **characterized in that** the solvent (d) contains not less than one type of solvent, and the boiling point of each of the not less than one type of solvent at normal pressure is not less than 100°C and less than 200°C.

8. The curable composition according to claim 1, **characterized in that** the content of the solvent (d) with respect to the whole curable composition is not less than 50 vol% and not more than 85 vol%.

9. The curable composition according to claim 1, **characterized in that** a ratio of a polyfunctional polymerizable compound in the polymerizable compound (a) is not less than 20 wt%.

10. The curable composition according to claim 1, **characterized in that** the polymerizable compound (a) contains not less than one type of polymerizable compound, and the boiling point of each of the not less than one type of polymerizable compound at normal pressure is not less than 250°C.

11. The curable composition according to claim 1, **characterized in that** the polymerizable compound (a) contains not less than one type of polymerizable compound, and a molecular weight of each of the not less than one type of polymerizable compound is not less than 200.

12. The curable composition according to claim 1, **characterized in that** as the polymerizable compound (a), at least a polymer having a polymerizable functional group is contained.

13. The curable composition according to claim 1, **characterized in that** a glass transition temperature of a cured product obtained by curing the polymerizable compound (a) in the state in which the solvent (d) is removed is not less than 70°C.

14. The curable composition according to claim 1, **characterized in that** the polymerizable compound (a) contains not less than one type of polymerizable compound, and a vapor pressure of each of the not less than one type of polymerizable compound at 80°C is not more than 0.001 mmHg.

15. The curable composition according to claim 1, **characterized in that** as the polymerizable compound (a), at least a compound (a-1) having one of an aromatic structure, an aromatic heterocyclic structure, and an alicyclic structure is contained.

16. The curable composition according to claim 1, **characterized in that** the polymerizable compound (a) contains not less than one type of polymerizable compound, and
an Ohnishi parameter (OP) of the polymerizable compound (a) is not less than 1.80 and not more than 4.00 and is a molar fraction weighted average value of an $N/(N_C-N_O)$ value of each molecule of the not less than one type of polymerizable compound, in which N is the number of all atoms in a molecule, $N_C$ is the number of carbon atoms in the molecule, and $N_O$ is the number of oxygen atoms in the molecule.

17. The curable composition according to claim 1, **characterized in that** as the polymerizable compound (a), at least a compound (a-2) containing at least Si atoms is contained.

18. The curable composition according to claim 17, **characterized in that** as the compound (a-2) containing at least Si atoms, at least a polymerizable compound having one of a silsesquioxane skeleton and a cyclic siloxane compound is contained.

19. The curable composition according to claim 1, **characterized in that** the curable composition in the state in which the solvent (d) is removed contains Si atoms of not less than 10 wt%.

20. The curable composition according to claim 1, **characterized in that** the curable composition is a curable composition for inkjet.

**21.** The curable composition according to claim 1, **characterized in that** a solubility coefficient of carbon dioxide to the curable composition is not less than 0.5 $kg/m^3 \cdot atm$ and not more than 10 $kg/m^3 \cdot atm$.

**22.** A film forming method of forming a film of a curable composition in a space between a mold and a substrate, **characterized by** comprising:

an arranging step of discretely arranging a plurality of droplets of a curable composition defined in any one of claims 1 to 21 on the substrate;
a waiting step of waiting until the plurality of droplets discretely arranged on the substrate bond to their respective adjacent droplets and form a continuous liquid film on the substrate; and
a contact step of bringing the mold and the liquid film on the substrate into contact with each other after the waiting step.

**23.** The film forming method according to claim 22, **characterized in that** in the waiting step, processing waits until a solvent contained in the liquid film volatilizes, and a content of the solvent becomes not more than 10 vol% with respect to the whole liquid film.

**24.** The film forming method according to claim 22, **characterized in that** in the waiting step, the substrate is heated at not less than 30°C and not more than 200°C for not less than 10 sec and not more than 600 sec.

**25.** The film forming method according to claim 22, **characterized in that** in the arranging step, droplets each having a volume of not less than 1.0 pL of the curable composition are arranged on the substrate at a density of not less than 80 $droplets/mm^2$.

**26.** The film forming method according to claim 22, **characterized in that** an average residual liquid film thickness as a value obtained by dividing a volume of the curable composition remaining after the waiting step by an area of a film formation region is not more than 20 nm.

**27.** The film forming method according to claim 22, **characterized in that**

the mold includes a pattern,
the pattern of the mold and the liquid film on the substrate are brought into contact with each other in the contact step, and
the film forming method further comprises, after the contact step, a curing step of curing the liquid film, thereby forming a cured film having a pattern corresponding to the pattern of the mold.

**28.** The film forming method according to claim 22, **characterized in that**

the mold includes a flat surface,
the flat surface of the mold and the liquid film on the substrate are brought into contact with each other in the contact step, and
the film forming method further comprises, after the contact step, a curing step of curing the liquid film, thereby forming a cured film having a surface conforming to the flat surface of the mold.

**29.** The film forming method according to claim 22, **characterized in that** in the arranging step, the plurality of droplets are discretely arranged on the substrate by using an inkjet method.

**30.** The film forming method according to claim 22, **characterized in that** in the contact step, a gas that fills a space between the substrate and the mold contains not less than 10% carbon dioxide in a molar ratio.

**31.** An article manufacturing method **characterized by** comprising:

a forming step of forming a film of a curable composition on a substrate using a film forming method defined in claim 22;
a processing step of processing the substrate on which the film is formed in the forming step; and
a manufacturing step of manufacturing an article from the substrate processed in the processing step.

FIG. 1

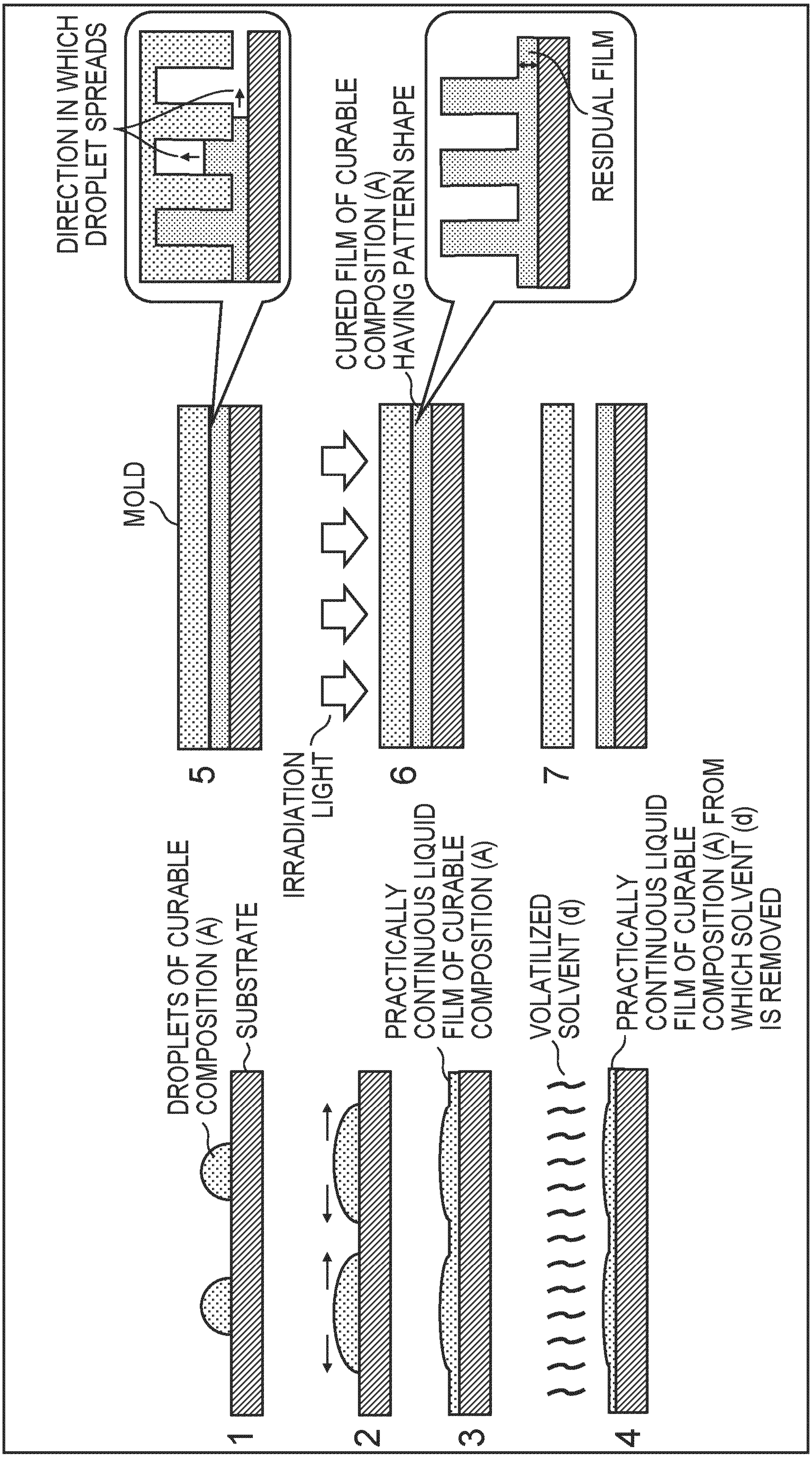
1
DROPLETS OF CURABLE COMPOSITION (A)
SUBSTRATE
2
3
PRACTICALLY CONTINUOUS LIQUID FILM OF CURABLE COMPOSITION (A)
VOLATILIZED SOLVENT (d)
4
PRACTICALLY CONTINUOUS LIQUID FILM OF CURABLE COMPOSITION (A) FROM WHICH SOLVENT (d) IS REMOVED
5
MOLD
DIRECTION IN WHICH DROPLET SPREADS
IRRADIATION LIGHT
6
CURED FILM OF CURABLE COMPOSITION (A) HAVING PATTERN SHAPE
RESIDUAL FILM
7

FIG. 2

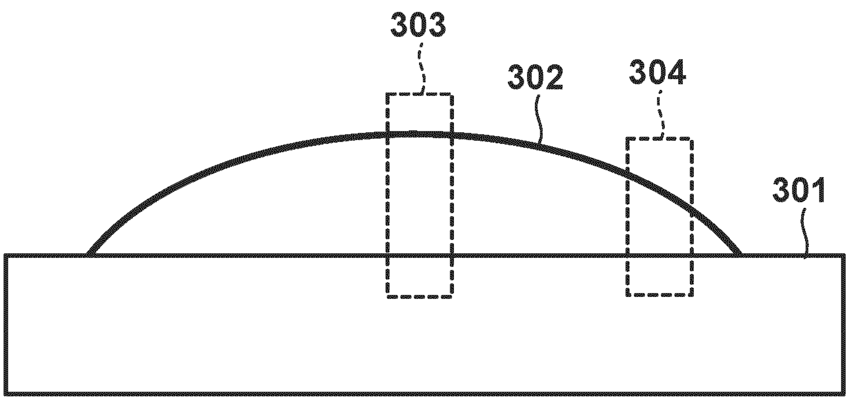


FIG. 3

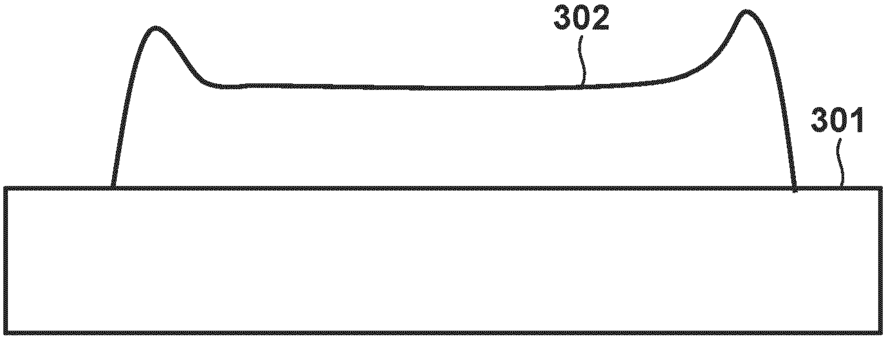

FIG. 4

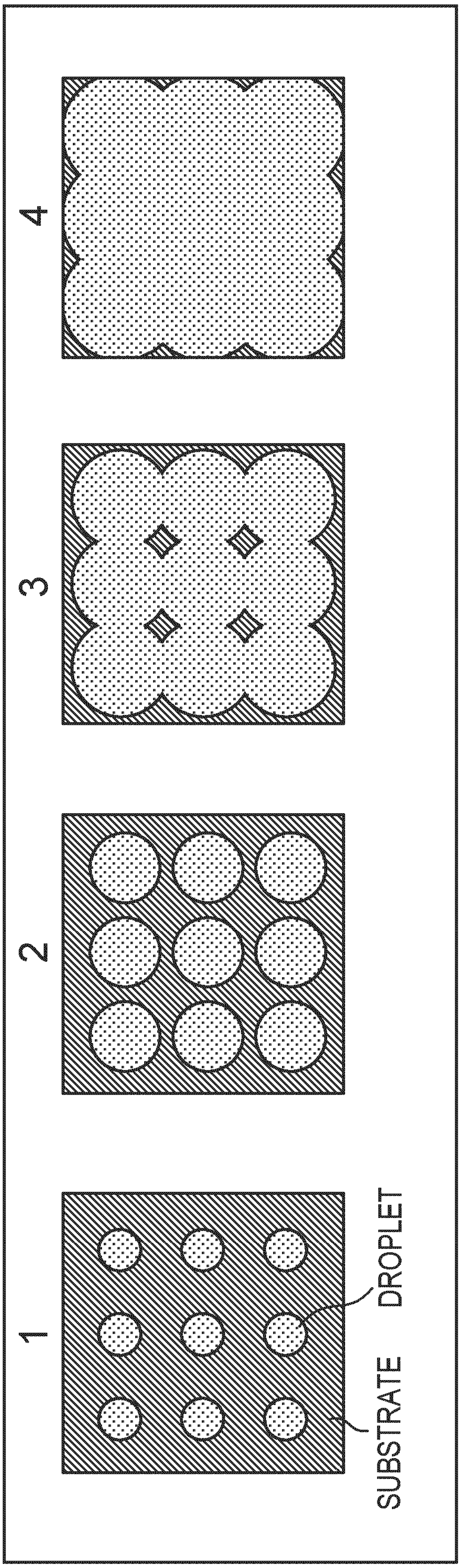

FIG. 5

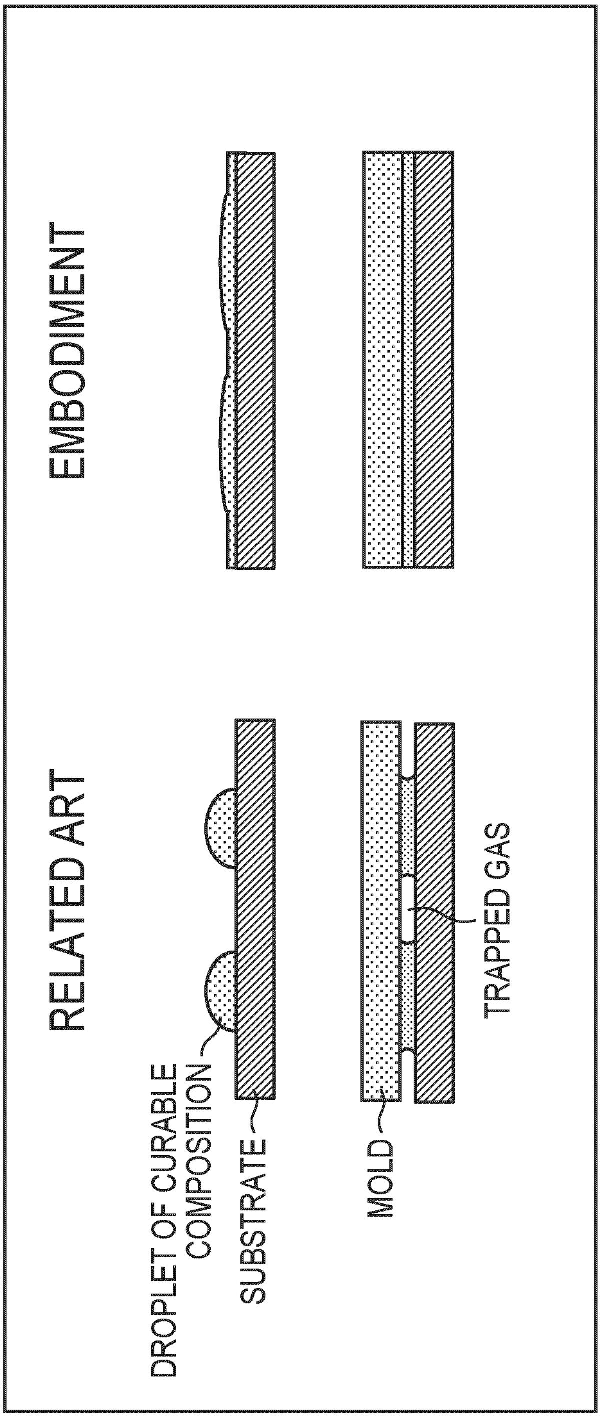
RELATED ART
EMBODIMENT
DROPLET OF CURABLE COMPOSITION
SUBSTRATE
MOLD
TRAPPED GAS

FIG. 6

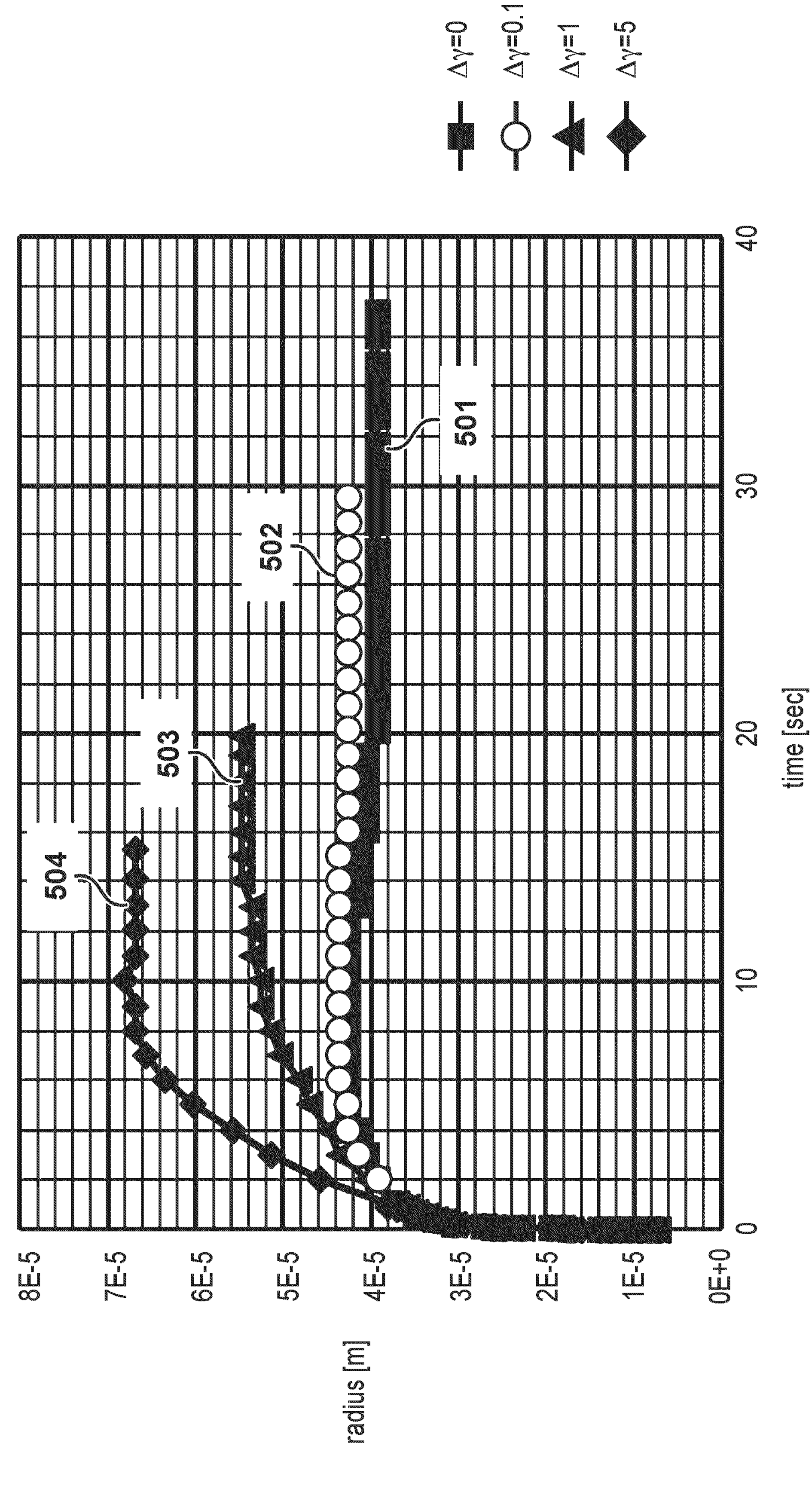

radius [m]
8E-5
7E-5
6E-5
5E-5
4E-5
3E-5
2E-5
1E-5
0E+0
0
10
20
30
40
time [sec]
501
502
503
504
Δγ=0
Δγ=0.1
Δγ=1
Δγ=5

FIG. 7

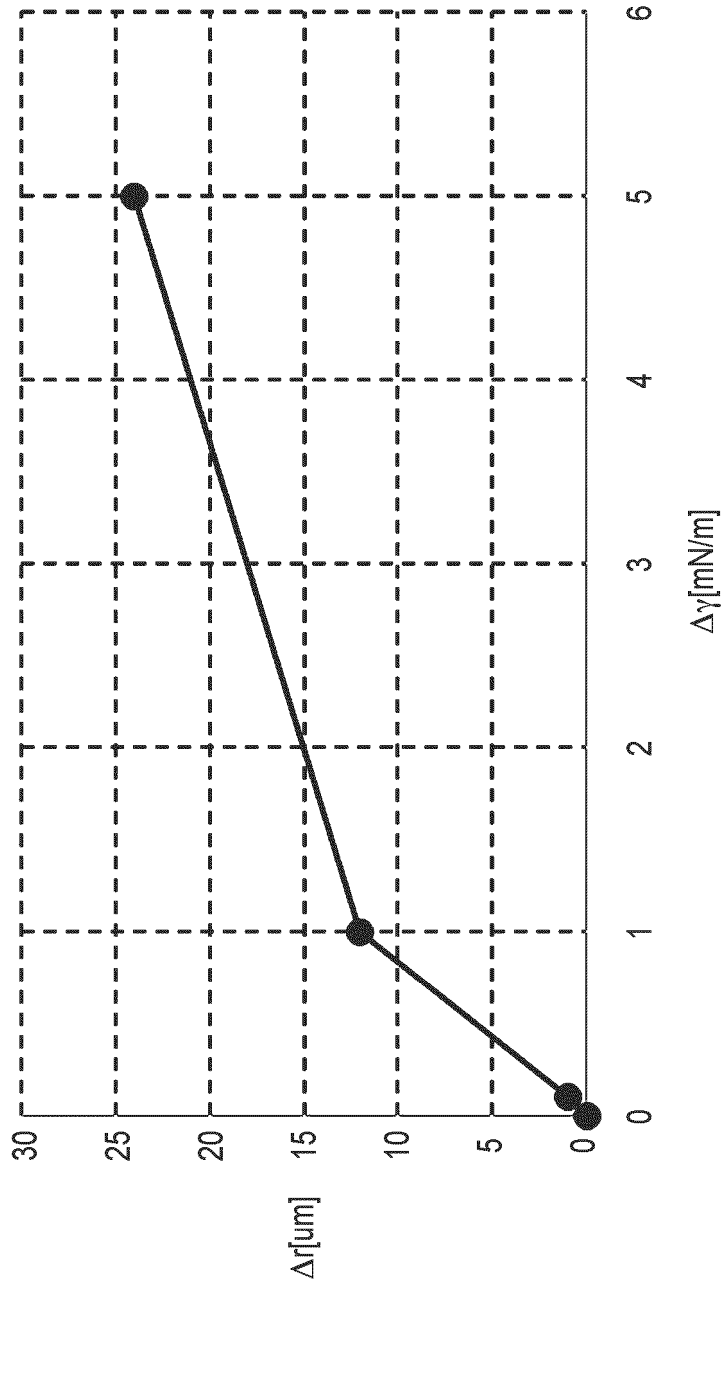

FIG. 8

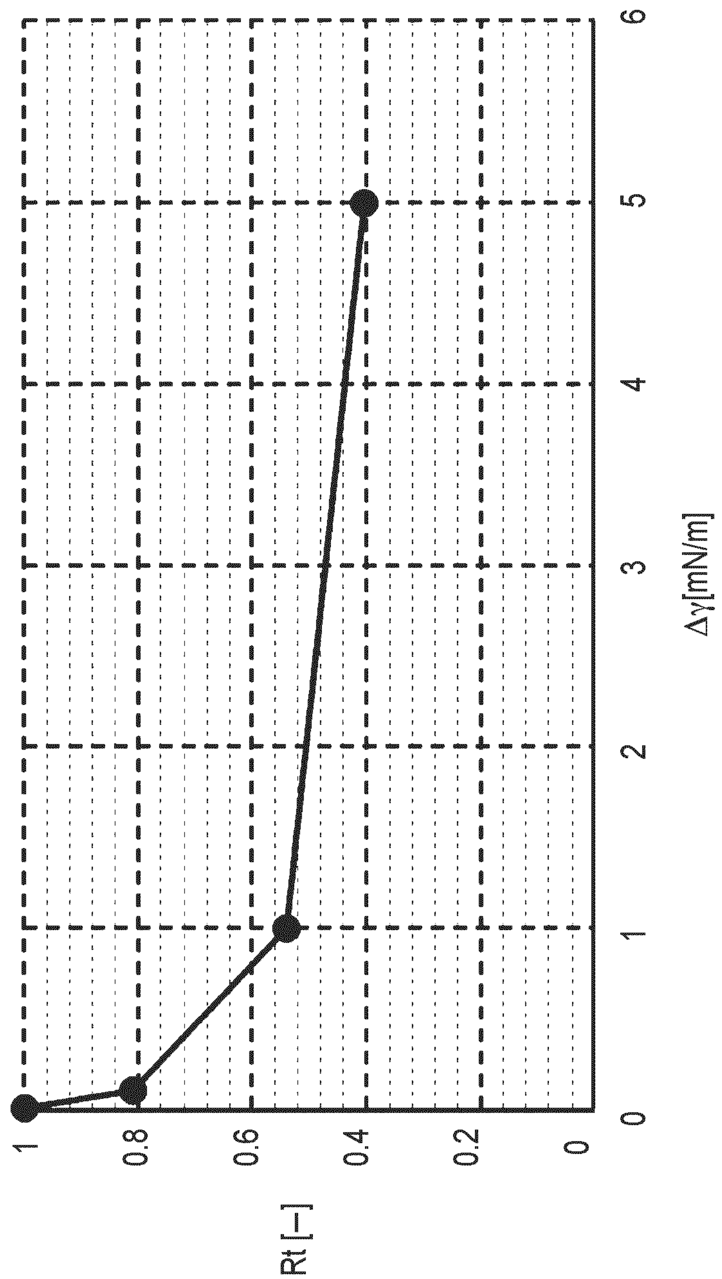

## INTERNATIONAL SEARCH REPORT

International application No. **PCT/JP2023/040496**

**A. CLASSIFICATION OF SUBJECT MATTER**

***C08L 33/08***(2006.01)i; ***B29C 59/02***(2006.01)i; ***H01L 21/027***(2006.01)i
FI: H01L21/30 502D; C08L33/08; B29C59/02 Z

According to International Patent Classification (IPC) or to both national classification and IPC

**B. FIELDS SEARCHED**

Minimum documentation searched (classification system followed by classification symbols)

H01L21/027; H01L21/30; B29C59/02

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X<br>A | WO 2017/170624 A1 (CANON KK) 05 October 2017 (2017-10-05)<br>paragraphs [0145], [0210]-[0211] | 1-3, 5-9, 12, 15<br>4, 10-11, 13-14, 16-31 |
| A | WO 2018/164017 A1 (CANON KK) 13 September 2018 (2018-09-13)<br>entire text, all drawings | 1-31 |
| A | WO 2018/051961 A1 (FUJIFILM CORP.) 22 March 2018 (2018-03-22)<br>entire text, all drawings | 1-31 |
| A | WO 2020/246405 A1 (FUJIFILM CORP.) 10 December 2020 (2020-12-10)<br>entire text, all drawings | 1-31 |

☐ Further documents are listed in the continuation of Box C. ☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **05 January 2024** | **16 January 2024** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | <br><br>Telephone No. |

Form PCT/ISA/210 (second sheet) (January 2015)

**INTERNATIONAL SEARCH REPORT**
**Information on patent family members**

International application No.
**PCT/JP2023/040496**

| Patent document cited in search report | Publication date (day/month/year) | Patent family member(s) | Publication date (day/month/year) |
|---|---|---|---|
| WO 2017/170624 A1 | 05 October 2017 | US 2017/0285466 A1<br>paragraphs [0184]-[0191], [0389]-[0406]<br>KR 10-2018-0126030 A<br>TW 201736087 A | |
| WO 2018/164017 A1 | 13 September 2018 | US 2019/0393026 A1<br>entire text, all drawings<br>US 2021/0265160 A1<br>KR 10-2019-0117760 A<br>CN 110546734 A<br>TW 201832904 A | |
| WO 2018/051961 A1 | 22 March 2018 | KR 10-2019-0039263 A<br>TW 201817582 A | |
| WO 2020/246405 A1 | 10 December 2020 | US 2022/0091503 A1<br>entire text, all drawings<br>KR 10-2022-0004192 A<br>TW 202108352 A | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 6584578 B
- JP 2019140394 A
- US 20200286740 A
- JP 2010530641 A
- JP 2022099271 A
- JP 2022190577 A
- JP 2023163584 A


### Non-patent literature cited in the description


- *Proc. SPIE 11324-11*, 2020
- *J. Electrochem. Soc.*, 1983, vol. 130, 143
- **OGAWA et al.** *Ultraviolet curable branched siloxanes as low-k dielectrics for imprint lithography*, https://doi.org/10.1116/1.4770051